(19) **Europäisches Patentamt European Patent Office Office européen des brevets**

(11) **EP 2 031 082 B1**

(12) **FASCICULE DE BREVET EUROPEEN**

(45) Date de publication et mention
de la délivrance du brevet:
**03.09.2014 Bulletin 2014/36**

(51) Int Cl.:
***C23C 16/02*** *(2006.01)* ***C23C 16/24*** *(2006.01)*
***H01L 31/0236*** *(2006.01)* ***H01L 31/18*** *(2006.01)*

(21) Numéro de dépôt: **07301336.9**

(22) Date de dépôt: **31.08.2007**

(54) **Substrat métallique texture cristallographiquement, dispositif texture cristallographiquement, cellule et module photovoltaique comprenant un tel dispositif et procédé de dépot de couches minces**

Metallsubstrat mit kristallographischer Struktur, Vorrichtung mit kristallographischer Struktur, Fotovoltaikzelle und modul, das eine solche Vorrichtung umfasst, und Depotverfahren von Dünnschichten.

Metal substrate with crystallographic texture, crystallographic texture device, photovoltaic cell and module comprising such a device and method of depositing fine layers

(84) Etats contractants désignés:
**AT BE BG CH CY CZ DE DK EE ES FI FR GB GR HU IE IS IT LI LT LU LV MC MT NL PL PT RO SE SI SK TR**

(43) Date de publication de la demande:
**04.03.2009 Bulletin 2009/10**

(73) Titulaires:
• **Aperam Alloys Imphy**
  **93200 Saint Denis (FR)**
• **Ecole Polytechnique**
  **91120 Palaiseau (FR)**

(72) Inventeurs:
• **Reyal, Jean Pierre**
  **95610 Eragny (FR)**

• **Reydey, Pierre-Louis**
  **58660 Coulanges Les Nevers (FR)**
• **Roca Cabarrocas, Pere**
  **91140 Villebon sur Yvette (FR)**
• **Djeridane, Yassine**
  **16040 Hussein-Dey (DZ)**

(74) Mandataire: **Domenego, Bertrand**
  **Cabinet Lavoix**
  **2, place d'Estienne d'Orves**
  **75441 Paris Cedex 09 (FR)**

(56) Documents cités:
  **WO-A-99/53554      WO-A-2004/063411**
  **WO-A-2005/121414    US-A- 5 964 966**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne un substrat métallique texturé cristallographiquement, un dispositif texturé cristallographiquement, une cellule et un module photovoltaïque comprenant un tel dispositif et un procédé de dépôt de couches minces.

Dans l'industrie des cellules photovoltaïques, le développement des couches minces à base de silicium sur des substrats céramiques, verres ou métalliques, est l'alternative à la pénurie actuelle de silicium monocristallin ou multi-cristallin massif. En effet, les technologies d'élaboration de films minces permettent de réduire considérablement les quantités de silicium utilisé.

Les cellules photovoltaïques à couches minces présentent actuellement deux filières d'élaboration distinctes. La première filière concerne les couches minces de silicium amorphe, polymorphe, nanocristallin et microcristallin. La deuxième filière concerne les couches minces de silicium polycristallin.

Dans la première filière, les couches minces de silicium amorphe sont généralement déposées à basses températures (100°C à 350°C) par des techniques plasma comme par exemple la technique de dépôt chimique en phase vapeur assistée par plasma (PECVD « Plasma Enhanced Chemical Vapor Deposition ») sur des substrats de verre ou encore sur des substrats flexibles et à faibles coûts tels que les polymères et aciers inoxydables.

Cette technologie présente des avantages à caractères économiques mais aussi deux points faibles majeurs qui sont un rendement de conversion limité à 10% en procédé industriel et une dégradation du rendement sous éclairement dite instabilité de Staebler-Wronski, dans le cas du silicium amorphe.

Le phénomène de dégradation peut être limité par l'élaboration de couches minces de silicium polymorphe caractérisées par l'incorporation de nano-cristallites de silicium au sein du silicium amorphe.

Dans le cas du silicium polycristallin, les procédés d'obtention du silicium ont recours à des étapes à haute température. Il est possible de déposer du silicium amorphe à basse température mais il est recristallisé par un recuit à haute température.

Il est difficile d'optimiser le compromis entre le rendement de conversion et le coût de fabrication des cellules photovoltaïques.

On connaît du document « Roedern, K. Zweibel and HS. Ullal, The role of polycrystalline thin-film PV technologies for achieving mid-term marketcompetitive PV modules - B.- 31st IEEE Photovoltaics Specialists Conference and Exhibition - NREL/CP-520-37353 - Lake Buena Vista, Florida, Juanuary 3-7, 2005 », des méthodes permettant d'élaborer des films minces de silicium polycristallin (poly-Si).

Il est aujourd'hui admis que pour obtenir un rendement élevé, il est nécessaire de développer des couches de silicium polycristallin, tel que décrit dans le document « Bergmann and JH. Werner, The future of crystalline silicon films on foreign substrates - Thin Solid Films, 403-404, 162-169, 2002 ».

L'augmentation significative du rendement de conversion des couches minces de silicium cristallisé nécessite la mise en oeuvre de techniques d'élaboration offrant une fraction volumique cristallisée importante et des grains de taille la plus élevée possible. Les procédés de dépôt usuels comportent une phase de dépôt de silicium amorphe ou partiellement cristallisé. Le degré de cristallisation dépend de la température de dépôt. Les procédés de dépôt usuels comportent également une phase de cristallisation du silicium amorphe au moyen d'un traitement thermique compris entre 600°C et 1000°C (ex : TTH sous vide, TTH laser) ou par introduction du film mince dans un réacteur spécifique (ex : plasma sous hydrogène, micro-ondes, etc).

Ainsi, diverses techniques de dépôt à hautes températures (T > 650°C), de films minces de silicium polycristallin, incluant par exemple des procédés en phase vapeur et des procédés de traitements thermiques en four statique ou au moyen d'un laser, ont initialement été utilisés.

Néanmoins, ces techniques de cristallisation entraînent des problèmes d'instabilité des substrats à haute température, ou d'interaction entre le substrat et les films minces.

Pour obtenir un dépôt et une cristallisation du silicium à basses températures (T < 600°C), il est connu, du document EP 0 571 632, de déposer du silicium amorphe sur du verre par les techniques de dépôt chimique en phase vapeur (CVD) ou de dépôt chimique en phase vapeur assistée par plasma (PECVD), à T < 450°C, puis à exposer le film mince dans un champ électrique micro-onde de 400W en présence d'hydrogène. On obtient un film mince de silicium polycristallin texturé selon une orientation préférentielle {110}.

WO 2005/121414 A1 divulgue un procédé de production d'un article multicouche avec des substrats métaliques comprenant du nickel.

Le document "T. Matsuyama, N. Bada, T. Sawada, S. Tsuge, K. Wakisaka, S. Tsuda, High-quality polycrystalline silicon thin film prepared by a solide phase crystallisation method, J. of non- Crystalline Solids, 198-200, 940-944, 1996", divulgue une autre solution consistant à déposer un premier film de silicium servant de couche de nucléation sur du quartz à 600°C par la technique de dépôt PECVD. Le film obtenu est constitué de cristaux de 0,1 $\mu$m de silicium disposés au sein de la phase amorphe.

Un second film amorphe de silicium est alors déposé par la technique de dépôt PECVD et cristallisé par un traitement thermique à 600°C pendant 10h.

On obtient un film mince cristallisé à structure colonnaire présentant un rendement de conversion de 9,2%.

D'autres solutions pour obtenir des couches minces polycristallines avec un rendement de conversion élevé, consistent à réaliser des structures à grains de silicium orientés ou épitaxiés.

Le document WO 96/17388 divulgue un procédé largement connu qui est l'utilisation de couches d'amorçage de silicium déposé à l'état amorphe puis cristallisé pour servir de germes de croissance épitaxique à la couche mince suivante. Ce procédé est un procédé multi-couches.

Le document US 5 340 410 divulgue une autre technique consistant à sélectionner une orientation {111} des grains de silicium, par attaque chimique sélective d'un film de silicium polycristallin à gros grains (40 $\mu$m à 50 $\mu$m, obtenu par traitement thermique), dans une solution d'hydroxyde de potassium. Un second film mince de silicium présentant une orientation {111} est alors obtenu par un procédé de dépôt en phase liquide (solution de métal liquide sursaturée en silicium).

Les méthodes de dépôt de l'art antérieur proposées ci-dessus ne permettent pas de régler les problèmes concernant le substrat. Il existe en effet deux classes de substrats employés selon la température d'élaboration.

Pour le dépôt de couches minces à base de silicium, certains substrats utilisés sont à une température de fusion élevée (T > 1000°C) : silicium, quartz, graphite, céramiques, métaux (par exemple titane), alliages et aciers.

D'autres substrats nécessitent une élaboration à basse température de fusion (T < 1000°C) : polymères et verre.

Comme vu précédemment, ces substrats présentent tous au moins un inconvénient majeur à être utilisés pour la fabrication industrielle de cellules photovoltaïques.

Un des objectifs de la présente invention est donc de proposer un substrat, mince, non fragile, flexible, ayant une température de fusion élevée et des caractéristiques structurales favorables à une croissance orientée ou épitaxiée des films minces

Un autre objectif de la présente invention est de proposer un dispositif formé d'un substrat métallique tel que décrit ci-dessus et d'une couche mince polycristalline à base de silicium et à usage photovoltaïque.

Un autre objectif de la présente invention est de proposer une cellule et un module photovoltaïque plus performants, permettant de piéger d'avantage la lumière et présentant ainsi un meilleur rendement électrique.

Un autre objectif de la présente invention est également de proposer un procédé de dépôt de couches minces permettant d'éviter toute pollution du silicium par le substrat.

A cet effet, l'invention concerne un substrat métallique texturé cristallographiquement comprenant une surface de connexion et une surface destinée à accueillir un dépôt de couche mince, ledit substrat métallique texturé cristallographiquement étant constitué d'un alliage présentant un système cristallin cubique à faces centrées et une texture cristallographique cube {100} <001> majoritaire, la surface destinée à accueillir le dépôt de couche mince comprenant des grains présentant majoritairement des plans cristallographiques {100} parallèles à la surface destinée à accueillir un dépôt de couche mince.

On entend par « texture cristallographique » une orientation préférentielle des cristaux de l'alliage par rapport au référentiel du substrat métallique. La texture est mesurée par diffraction des rayons X et représentée par des figures de pôles, comme décrit plus loin.

Selon l'invention, l'alliage constituant le substrat métallique texturé cristallographiquement est un alliage fernickel dont la composition comprend, en % en poids par rapport au poids total de l'alliage:

$$Ni \geq 30\ \%,$$

$$Cu \leq 15\ \%,$$

$$Cr \leq 15\ \%,$$

$$Co \leq 12\ \%,$$

$$Mn \leq 5\ \%,$$

$$S < 0{,}0007\ \%,$$

$$P < 0{,}003\ \%,$$

$$B < 0{,}0005\ \%,$$

$$Pb < 0{,}0001\ \%,$$

- les pourcentages en nickel, chrome, cuivre, cobalt et manganèse sont tels que l'alliage satisfait la condition suivante :

$$34\ \% \le (Ni + Cr + Cu/2 + Co/2 + Mn),$$

et

- l'alliage comprend jusqu'à 1% en poids d'un ou plusieurs éléments désoxydants choisis parmi le silicium, le magnésium, l'aluminium et le calcium, le reste des éléments constituant l'alliage étant du fer et des impuretés.
Dans différents modes de réalisation possibles, la présente invention concerne également les caractéristiques suivantes qui pourront être considérées isolément ou selon toutes leurs combinaisons techniquement possibles et apportent chacune des avantages spécifiques :

•les pourcentages en nickel, chrome, cuivre, cobalt et manganèse sont tels que l'alliage satisfait la condition suivante :

$$34\ \% \le (Ni + Cr + Cu/2 + Co/2 + Mn) \le 54\ \%,$$

le coefficient moyen de dilatation, entre 20°C et 100°C, $\alpha_{20}^{100}$ de l'alliage étant supérieur à $10^{-6}$ $K^{-1}$, et de préférence compris entre $10^{-6}$ $K^{-1}$ et $10\ 10^{-6}$ $K^{-1}$,

-la surface destinée à accueillir un dépôt de couche mince du substrat métallique texturé cristallographiquement présente une rugosité $R_a$ inférieure à 150 nm, et de préférence inférieure à 50 nm,
-le substrat métallique texturé cristallographiquement est mince avec une épaisseur comprise entre 0,5 mm et 0,05 mm, de préférence de l'ordre de 0,1 mm,
-les grains sur la surface destinée à accueillir un dépôt de couche mince sont gravés en forme de pyramide présentant des plans {111} et des marches selon les plans {100} de façon à former un réseau de type réseau blazé.
Le substrat métallique texturé cristallographiquement, selon l'invention, présente les avantages d'être mince, non fragile, flexible, avec une température de fusion élevée, un paramètre de maille proche de celui du silicium et des semiconducteurs à base de silicium, une rugosité de surface contrôlée avant gravure chimique, une géométrie de surface après gravure chimique permettant de réduire la réflectivité du substrat métallique texturé cristallographiquement et une dilatation adaptée à celle du silicium.
L'invention concerne également un dispositif texturé cristallographiquement.
Selon l'invention, il comprend un substrat métallique texturé cristallographiquement, tel que défini précédemment, sur lequel a été déposé une couche mince polycristalline à base de silicium, la couche mince polycristalline présentant une orientation cristallographique préférentielle {100} et {111}.
On entend par « à base de silicium », une couche mince polycristalline pouvant comprendre soit pratiquement que du silicium, du silicium dopé ou une composition comprenant du silicium et d'autres éléments chimiques (par exemple une couche mince de composition $Si_xGe_{1-x}$).
La couche mince polycristalline à base de silicium déposée sur le substrat présente une fraction volumique de silicium cristallisé importante, une fraction volumique de gros grains de silicium importante et des grains de silicium orientés.
Une telle association substrat métallique texturé cristallographiquement /couche mince polycristalline à base de silicium permet de réduire considérablement les quantités de silicium utilisé.
La distribution de la lumière dans la couche mince de silicium est également améliorée.
Dans différents modes de réalisation possibles, la présente invention concerne également les caractéristiques suivantes qui pourront être considérées isolément ou selon toutes leurs combinaisons techniquement possibles et apportent chacune des avantages spécifiques :

- le paramètre de maille cristalline du substrat métallique texturé cristallographiquement est identique ou presque à celui de la couche mince polycristalline à base de silicium,
- le coefficient moyen de dilatation de l'alliage constituant le substrat métallique texturé cristallographiquement est proche de celui de la couche mince polycristalline,
- la couche mince polycristalline à base de silicium présente une épaisseur inférieure à 10 μm, de préférence inférieure à 5 μm, et comprend des cristaux de silicium de dimension comprise entre 0,1 et 2 μm.

La couche mince polycristalline à base de silicium déposée sur le substrat métallique texturé cristallographiquement présente une fraction volumique de silicium cristallisé importante, une fraction volumique de gros grains de silicium importante et des grains de silicium orientés. L'orientation des grains présents sur la surface du substrat métallique texturé cristallographiquement est reprise en partie par le silicium.

Une telle association substrat métallique texturé cristallographiquement /couche mince polycristalline à base de silicium permet de réduire considérablement les quantités de silicium utilisé (couche d'épaisseur inférieure à 5 μm).

La distribution de la lumière dans la couche mince polycristalline de silicium est également améliorée.

Le fait que le coefficient moyen de dilatation de l'alliage fer-nickel soit proche de celui du film mince polycristallin à base de silicium permet de limiter les contraintes thermiques générées sur le film polycristallin à base de silicium en fonctionnement et d'augmenter la durée de vie des cellules photovoltaïques.

L'invention concerne également une cellule photovoltaïque.

Selon l'invention, elle comprend un dispositif texturé cristallographiquement, tel que défini précédemment.

Dans différents modes de réalisation possibles, la présente invention concerne également les caractéristiques suivantes qui pourront être considérées isolément ou selon toutes leurs combinaisons techniquement possibles et apportent chacune des avantages spécifiques :

- la cellule photovoltaïque comprend :

  • un dispositif texturé cristallographiquement dans lequel :

    ■ le substrat métallique texturé cristallographiquement présente une teneur en nickel égale à 41% en poids par rapport au poids total de l'alliage constituant le substrat métallique,
    ■ le silicium de la couche mince de silicium est dopé,

  • une couche mince de silicium intrinsèque polycristallin déposée sur le dispositif texturé cristallographiquement,
  • une couche mince de silicium polycristallin dopé déposée sur la couche mince de silicium intrinsèque polycristallin,
  • une couche mince d'un oxyde transparent conducteur déposée sur la couche mince de silicium polycristallin dopé, et
  • une grille métallique disposée sur la couche mince d'oxyde transparent conducteur et comprenant plusieurs éléments dont un élément de grille central.

- le dispositif texturé cristallographiquement et les différentes couches minces sont traversés par un connecteur relié à l'élément de grille central et débouchant à l'extérieur de la cellule photovoltaïque à travers la surface de connexion du substrat métallique texturé cristallographiquement, ledit connecteur étant entouré d'un isolant s'étendant depuis la surface de connexion du substrat métallique texturé cristallographiquement jusqu'à l'élément de grille central.

L'invention concerne également un module photovoltaïque.

Selon l'invention, le module photovoltaïque comprend :

- une couche mince de polymère,
- deux couches minces de colle thermoréactivable, dont une première et une deuxième couches minces de colle thermoréactivable, la première couche mince de colle thermoréactivable étant déposée sur la couche mince de polymère,
- une couche conductrice formée d'une pluralité de cellules photovoltaïques, telles que définies précédemment, et de deux bandes de cuivre disposées aux extrémités respectives de la couche conductrice formée d'une pluralité de cellules photovoltaïques, lesdites cellules photovoltaïques étant sous forme de bandes et les deux bandes de cuivre étant disposées entre les première et deuxième couches minces de colle thermoréactivable, parallèlement les unes par rapport aux autres, inclinées par rapport aux couches minces de colle thermoréactivable et en se chevauchant de façon à former une rangée de cellules photovoltaïques et de bandes de cuivre en contact selon une direction parallèle aux couches minces de colle thermoréactivable, la pluralité de cellules photovoltaïques et les deux bandes de cuivre formant une connexion en série, et

- une couche mince de polyméthylméthacrylate déposée sur la deuxième couche mince de colle thermoréactivable.

Selon l'invention, la cellule et le module photovoltaïque sont plus performants, et permettent de piéger d'avantage la lumière. Un rayon lumineux frappant orthogonalement la cellule ou le module photovoltaïque aura tendance à se réfléchir et à rester piégé dans la couche mince polycristalline à base de silicium. Le rendement électrique de la cellule ou du module photovoltaïque est amélioré. Pour une même quantité d'énergie lumineuse incidente sur la surface de la cellule ou du module photovoltaïque, la quantité d'énergie électrique convertie et obtenue avec une telle cellule ou un tel module photovoltaïque est supérieure par rapport à la quantité d'énergie électrique obtenue avec une cellule ou un module photovoltaïque de l'art antérieur.

L'invention concerne également un procédé de dépôt de couches minces à base de silicium sur un substrat métallique texturé cristallographiquement, tel que défini précédemment.

Selon l'invention, il est réalisé par une méthode de dépôt chimique en phase vapeur (CVD), la température du plasma étant inférieure à 300°C, de préférence de l'ordre de 200°C.

Dans différents modes de réalisation possibles, la présente invention concerne également les caractéristiques suivantes qui pourront être considérées isolément ou selon toutes leurs combinaisons techniquement possibles et apportent chacune des avantages spécifiques :

- la méthode de dépôt chimique en phase vapeur (CVD) est une méthode de dépôt chimique en phase vapeur assisté par plasma radiofréquence (RFPECVD), le plasma comprenant un mélange gazeux de silane nous avons utilise le SiF4, d'hydrogène et d'argon, et la puissance radiofréquence utilisée étant de l'ordre de 16 W.
- la croissance épitaxiale du silicium est obtenue à partir de nanocristaux de silicium synthétisés dans le plasma.

Le procédé de dépôt de couches minces réalisé à basse température permet d'éviter toute pollution du silicium par les éléments constituant le substrat métallique texturé cristallographiquement.

Les rendements de conversion sont également améliorés.

Le substrat métallique texturé cristallographiquement permet de favoriser les mécanismes de croissance épitaxiale ou orientée à gros grains du silicium, directement pendant les phases de dépôts.

L'invention sera décrite plus en détail en référence aux dessins annexés dans lesquels :

- la figure 1 représente une figure de pôle {111} qui est caractéristique de la texture cristallographique cube majoritaire ;
- la figure 2 représente une figure de pôle {111} qui est caractéristique de la texture cristallographique cube + macle/cube ;
- la figure 3 représente une figure de pôle {111} qui est caractéristique d'une texture cristallographique isotrope ;
- la figure 4 représente deux figures de pôles {111} de films minces de silicium polycristallin obtenus selon deux modes de réalisation différent de l'invention ;
- les figures 5a et 5b représentent des observations à des agrandissements différents, réalisées au microscope électronique à balayage, obtenues après gravure chimique de la surface d'un substrat métallique texturé cristallographiquement comprenant un alliage fer-nickel avec 41 % de nickel ;
- la figure 6 représente un dispositif texturé cristallographiquement comprenant un substrat métallique texturé cristallographiquement ayant subi une gravure chimique ;
- la figure 7 représente la répartition des cavités pyramidales après gravure chimique de la surface du substrat ;
- la figure 8 représente une cellule photovoltaïque, selon un mode de réalisation de l'invention ;
- la figure 9 représente une cellule photovoltaïque à contact arrière, selon un autre mode de réalisation de l'invention ;
- la figure 10 représente un module photovoltaïque, selon un mode de réalisation de l'invention ;
- la figure 11 représente une bande de substrat métallique texturé cristallographiquement comprenant des sillons gravés ;
- la figure 12 représente un mode opératoire de dépôt de couches minces par décomposition chimique des gaz réactifs dans un plasma de décharge à basse température ;
- la figure 13 représente un agrandissement de la zone de croissance du silicium sur la couche mince polycristalline pendant le mode opératoire.

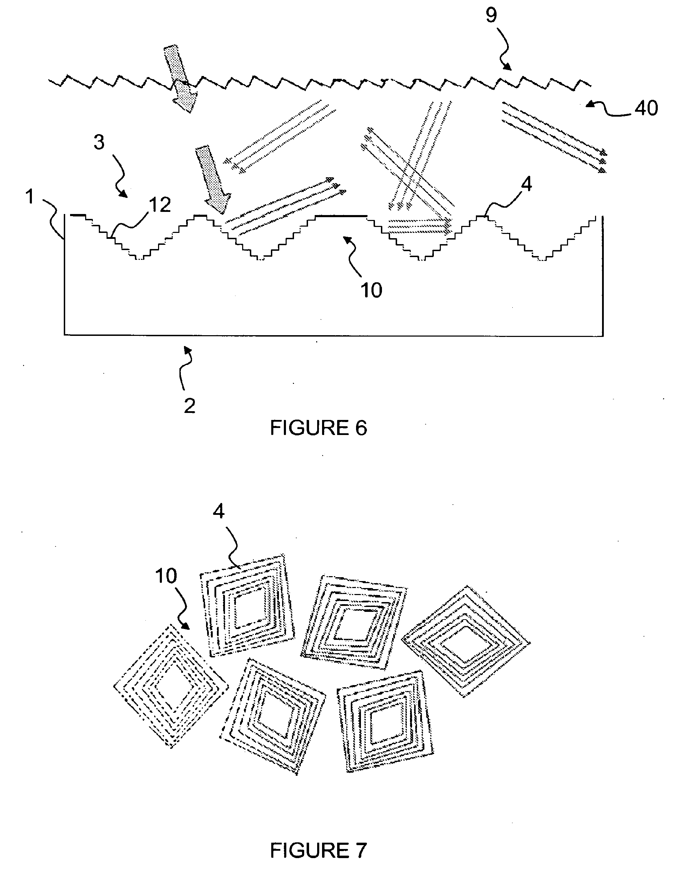

L'invention concerne un substrat métallique texturé cristallographiquement 1 comprenant une surface de connexion 2 et une surface 3 destinée à accueillir un dépôt de couche mince, comme représenté sur la figure 6. Le substrat métallique texturé cristallographiquement 1 est constitué d'un alliage présentant un système cristallin cubique à faces centrées et une texture cristallographique cube {100} <001> majoritaire. La surface destinée à accueillir le dépôt de couche mince 3 comprend des grains 4 présentant majoritairement des plans cristallographiques {100} parallèles à la surface 3 destinée à accueillir un dépôt de couche mince. L'alliage constituant le substrat métallique texturé cristallographiquement 1 doit avoir une énergie de défaut d'empilement élevée.

Selon un exemple de mode de réalisation de l'invention, l'alliage constituant le substrat métallique texturé cristallographiquement 1 est un alliage fer-nickel comprenant au moins 30% de nickel et pouvant comprendre des éléments de substitution du nickel tels que le chrome, le cuivre, le cobalt ou le manganèse. Ces éléments doivent respecter la relation suivante :

$$34\% \leq (Ni + Cr + Cu/2 + Co/2 + Mn) ;$$

Les teneurs en éléments de substitution du nickel sont par ailleurs limitées comme suit : la teneur en cuivre est inférieure ou égale à 15% en poids, la teneur en chrome est inférieure ou égale à 15% en poids, la teneur en cobalt est inférieure ou égale à 12% en poids, et la teneur en manganèse est inférieure ou égale à 5% en poids.

De manière préférée, les teneurs en nickel, chrome, cuivre, cobalt et manganèse sont telles que :

$$34\% \leq (Ni + Cr + Cu/2 + Co/2 + Mn) \leq 54 \% ;$$

L'alliage ainsi défini présente un coefficient moyen de dilatation $\alpha_{20}^{100}$, entre 20°C et 100°C, supérieur à $10^{-6}$ $K^{-1}$, et de préférence compris entre $10^{-6} K^{-1}$ et $10 \cdot 10^{-6} K^{-1}$.

L'alliage peut également comprendre jusqu'à 1% d'éléments de désoxydation choisis parmi le silicium, le magnésium, l'aluminium et le calcium.

L'alliage peut également comprendre des éléments chimiques résiduels résultant de l'élaboration. La teneur en éléments chimiques résiduels doit être réduite au minimum et ne pas excéder 1 % en poids par rapport au poids total de l'alliage. Les impuretés sont constituées des éléments chimiques suivants :

titane, molybdène, tungstène, niobium, tantale et vanadium qui doivent vérifier la relation suivante :

$$(Ti + Mo + W + Nb + Ta + V) \leq 1\% ;$$

Les éléments connus pour affecter la solidification et la transformation à chaud des alliages fer-nickel doivent être réduits également au minimum. La teneur en souffre doit être inférieure à 0,0007% en poids par rapport au poids total de l'alliage. La teneur en phosphore doit être inférieure à 0,003% en poids par rapport au poids total de l'alliage. La teneur en bore doit être inférieure à 0,0005% en poids par rapport au poids total de l'alliage. Et la teneur en plomb doit être inférieure à 0,0001% en poids par rapport au poids total de l'alliage.

Ce qui suit décrit le procédé de fabrication du substrat métallique texturé cristallographiquement 1.

Les documents, "Recrystallisation and related annealing phenomena - FJ. Humphreys, M. Hatherly - ed. Pergamond, p.328, 1995" et EP 0 792 943 décrivent des procédés d'élaboration de substrats métalliques texturés cristallographiquement.

Il est connu de ces documents que la texture cristallographique de recristallisation cube {100} <001> se développe dans les alliages ayant un système cristallin cubique faces centrées (cfc), à moyenne et forte énergie de défaut d'empilement. Plusieurs facteurs favorables au développement de la texture cristallographique cube sont clairement identifiés :

- le substrat métallique texturé cristallographiquement doit subir un taux de déformation par laminage à froid très élevé, au moins supérieur à 80%, et de préférence supérieur à 90%. La texture cristallographique cube est d'autant plus intense que le taux de déformation avant traitement thermique est élevé ;
- un traitement thermique de recristallisation primaire du substrat métallique texturé cristallographiquement fortement écroui est nécessaire ;
- les concentrations en éléments chimiques résiduels tels que le titane, le molybdène, le tungstène, le niobium, le tantale ou le vanadium dans l'alliage doivent être inférieures à 1 %. La teneur critique dépend de l'élément chimique considéré ;
- la taille des grains avant déformation sévère doit être la plus fine possible ;
- enfin, la température de laminage doit être supérieure à la température ambiante.

Le procédé de fabrication du substrat métallique texturé cristallographiquement 1, selon un exemple de réalisation de l'invention, comprend une étape d'élaboration de l'alliage constituant le substrat métallique texturé cristallographiquement 1.

L'alliage constituant le substrat métallique texturé cristallographiquement 1 est élaboré dans un four électrique à arc, coulé en lingots ou directement sous forme de brames au moyen d'une coulée continue de brames. Les lingots comme les brames sont transformés à chaud de façon à obtenir des bandes à chaud dont l'épaisseur est comprise entre 1,5 mm et 13 mm.

Les bandes à chaud sont décapées et polies pour obtenir des bobines présentant une surface sans défaut, c'est à dire : sans calamine, sans pénétration oxydée, sans paille, homogène en épaisseur dans le sens travers et le sens long des feuilles d'alliage.

Le procédé de fabrication du substrat métallique texturé cristallographiquement 1 comprend également une étape de laminage et texturation cristallographique des bandes.

Les bandes à chaud sont transformées par laminage à froid. Le taux de réduction, $\varepsilon = (e_i - e_f)/e_i$, où $e_i$ et $e_f$ sont respectivement l'épaisseur initiale et l'épaisseur finale des feuilles d'alliage, doit être supérieur à 85%, et de préférence $\varepsilon > 90\%$. Ce taux de déformation sévère avant traitement thermique est indispensable pour préparer la microstructure de l'alliage. On obtient ainsi une feuille d'alliage fortement écrouie dont l'épaisseur est comprise entre 0.05 mm et 1 mm. Tout procédé de déformation sévère par laminage à froid symétrique ou asymétrique (c'est à dire avec vitesses circonférentielles des cylindres de travail du laminoir identiques ou différentes) produisant une déformation supérieure à 90% est applicable pour développer la texture cristallographique cube et plus particulièrement le procédé décrit dans le document « Ultra-Grain refinement of 36%Ni steel by accumulative roll-bonding process - K. Inoue, N. Tsuji, Y. Saito - International symposium on Ultrafine Grained Steels (ISUGS 2001) 126-129 - The Iron and Steel Institute of Japan ».

Le procédé de fabrication du substrat métallique texturé cristallographiquement 1 comprend également une étape de transfert de rugosité.

Le procédé ci dessous est cité comme exemple, non unique, de réalisation.

La rugosité des feuilles d'alliage est maîtrisée au cours des passes de laminage. On réalise par exemple à partir d'une bande laminée à chaud de 3 mm d'épaisseur, une feuille d'alliage écrouie de 95%, c'est à dire ayant une épaisseur finale de 0,15 mm.

Le laminage à froid est réalisé, par exemple, en 13 passes de 20% sur un laminoir réversible avec des cylindres de faible rugosité. En fin de chaque passe, la rugosité de la feuille d'alliage n'excède pas 200 nm.

La 14$^{\text{ème}}$ passe de laminage est celle qui réalise le transfert de rugosité souhaité. Le taux de réduction est inférieur à 20%, et plus précisément inférieur à 7%, il est appelé 'skin-pass'. Cette dernière passe est réalisée avec un cylindre de très faible rugosité pour obtenir la rugosité $R_a$ visée ($R_a \sim 30$ nm).

Le procédé de fabrication du substrat métallique texturé cristallographiquement 1 comprend également une étape de texturation cristallographique des bandes.

Après laminage à froid, la feuille d'alliage est soumise à un traitement thermique (TTH) de recristallisation primaire, sous atmosphère protectrice, de façon à développer la texture cristallographique cube {100} <001> recherchée, sans oxyder la surface de la bande.

Le traitement thermique peut être réalisé dans un four statique ou dans un four au défilé, sous hydrogène ou sous vide primaire. Le couple temps t, température T°C, doit être ajusté pour développer une texture cristallographique cube intense et peu désorientée. Si la température est trop élevée (par exemple : T > 1100°C) ou si la durée est trop longue (par exemple 6 h à 1080°C), le traitement thermique peut générer une recristallisation secondaire qui détruit la composante cube recherchée au détriment d'autres composantes aléatoires indésirables. Les traitements thermiques types sont :

T = 1050°C, t = 0.2mn à t = 2mn ;
T = 1000°C, t = 0.5mn à t = 60mn ;
T = 950°C, t = 2mn à t = 200mn ;
T = 900°C, t = 8mn à t = 600mn.

A l'issue du traitement thermique final, la feuille d'alliage présente une texture cristallographique cube intense et faiblement désorientée, avec une taille de grains comprise entre 1 $\mu$m et 100 $\mu$m et une rugosité moyenne $R_a$ inférieure à 50 nm, permettant l'utilisation directe de l'alliage après un simple dégraissage.

La feuille d'alliage est alors planée et cisaillée à la largeur déterminée par le procédé de dépôt du silicium.

On obtient un substrat métallique 1 présentant une texture cristallographique cube {100}<001> intense et faiblement désorientée.

La représentation d'une texture cristallographique revient à définir l'orientation des grains par rapport au référentiel échantillon constitué, dans le cas d'un substrat ayant subi une gamme de laminage à froid, par la direction de laminage (DL), la direction transverse (DT) et la direction normale (DN).

Les orientations ou composantes de textures cristallographiques sont décrites par les indices de Miller {hkl}<uvw>, où {hkl} désigne la famille de plans cristallographiques des grains parallèles au plan de laminage et <uvw> la famille de directions cristallographiques des grains parallèles à la direction de laminage.

Une texture cristallographique est généralement décrite par diffraction des rayons X selon la méthode en réflexion de Schulz. L'échantillon est placé au centre d'un goniomètre de texture cristallographique en position de diffraction, à un angle de Bragg $\Theta$, correspondant aux conditions de diffraction d'une famille de plans {hkl}. Il est alors soumis aux rotations $\psi$ (axe parallèle à DT) et $\varphi$ (axe parallèle à DN). En position $\psi$ et $\varphi$ donnés, l'intensité du faisceau recueilli par le compteur RX est proportionnelle au nombre de grains dont les plans {hk!} sont en condition de diffraction. En faisant varier $\psi$ de 0° à 90° et $\varphi$ de 0° à 360° toutes les composantes de la texture cristallographique sont mesurées.

La texture cristallographique du substrat métallique texturé cristallographiquement 1 est alors représentée sous forme de figures de pôles au moyen des projections stéréographiques des distributions de densités des normales aux plans {hkl} diffractant.

La texture cristallographique du substrat est caractérisée par la présence d'une composante cube quasi-unique, intense et faiblement désorientée. La composante cube quasi-unique est en général associée à la composante {221}<122>, nommée macle/cube, et qui doit être minimisée.

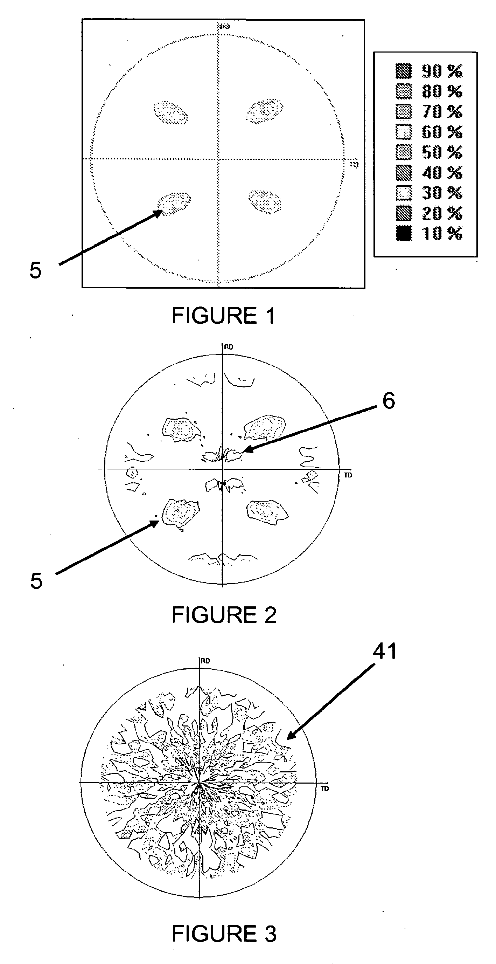

Les figures 1 à 3 montrent des exemples de figures de pôles {111} mesurées sur des substrats métalliques d'alliage fer-nickel à système cristallin cubique faces centrées comprenant une teneur de 41 % de nickel par rapport au poids total de l'alliage.

La figure 1 représente une figure de pôle {111} qui est caractéristique de la texture cristallographique cube majoritaire recherchée. La figure 2 représente une figure de pôle {111} qui est caractéristique de la texture cristallographique cube + macle/cube et la figure 3 représente une figure de pôle {111} qui est caractéristique d'une texture cristallographique isotrope.

La figure 1 montre la présence de pôles {111} 5 de la texture cristallographique cube {100}<001> majoritaire, intense et peu désorientée. Dans les mêmes conditions de mesure, la figure 2 montre le cas où la composante macle/cube {221}<122> 6 est non négligeable par rapport à la composante cube moins intense et plus désorientée. La figure 3 montre un exemple de structure isotrope caractérisée par la présence de toutes les orientations possibles distribuées uniformément. Les figures 2 et 3 sont celles à éviter.

Le caractère unique et intense de la texture cristallographique cube peut être quantifié par le ratio : R = Ic/Imc. Ic est l'intensité maximum diffractée par les plans {111} au voisinage de l'orientation idéale (001)[100] : $\psi \sim 54.74°$ et $\varphi \sim 45°$. Icm est l'intensité maximum diffractée par les plans {111} au voisinage de l'orientation idéale (122)[221] : $\psi \sim 15.79°$ et $\varphi \sim 13.63°$.

Le ratio R = Ic/Imc doit être le plus élevé possible (R > 10).

La désorientation de la texture cristallographique cube peut être obtenue par la mesure de la largeur à mi-hauteur des intensités diffractées par les plans {111} au voisinage de l'orientation idéale (001)[100], c'est-à-dire en $\psi \sim 54.74°$ et $\varphi \sim 45°$, lorsque l'on fait varier l'angle $\psi$ de $+/-\Delta\psi$ et $\varphi$ de $+/-\Delta\varphi$.

La désorientation totale en $\varphi$ mesurée à mi-hauteur doit être : $\delta\varphi < 20°$.

La désorientation totale en $\psi$ mesurée à mi-hauteur doit être : $\delta\psi < 20°$.

La figure de pôle 1 est donnée pour un substrat métallique texturé cristallographiquement 1 présentant un ratio R = 18.5, $\delta\varphi = 11,5°$ et $\delta\psi = 11,9°$, un taux d'écrouissage de 91% et une épaisseur de 0,15 mm.

La rugosité moyenne $R_a$ du substrat métallique texturé cristallographiquement 1 doit être faible. La rugosité est l'état micro-géométrique de la surface.

Mesuré au moyen d'un rugosimètre, la rugosité moyenne $R_a$ est définie par l'expression :

$$R_a = \frac{1}{L_0} \int_0^l |Z(x)| \cdot dx$$

Le substrat métallique texturé cristallographiquement 1 doit avoir une rugosité moyenne mesurée dans le sens travers très faible : $R_a < 150$ nm et de préférence inférieure à 50 nm.

La taille des grains à la surface du substrat métallique texturé cristallographiquement 1 est supérieure à 1 $\mu$m.

Le substrat métallique texturé cristallographiquement 1 est mince avec une épaisseur comprise entre 0,5 mm et 0,05 mm, de préférence de l'ordre de 0,1 mm.

L'invention concerne également un dispositif texturé cristallographiquement 13 comprenant un substrat métallique texturé cristallographiquement 1, tel que défini précédemment, sur lequel a été déposé une couche mince polycristalline à base de silicium 11 (Si ou $Si_xGe_{1-x}$ par exemple). Un tel dispositif texturé cristallographiquement 13 est représenté sur la figure 6. Le dispositif texturé cristallographiquement 13 est destiné à la fabrication de cellules photovoltaïques ou pour déposer des couches de silicium pour créer des dispositifs semi-conducteurs. Plus précisément, la couche mince polycristalline à base de silicium 11 est déposée sur la surface 3 du substrat destinée à accueillir un dépôt de couche mince. Sur cette figure, il est représenté un ensemble de couches minces 40, qui seront décrites plus loin, comprenant, entre autre, la couche mince polycristalline à base de silicium 11 qui est en contact avec le substrat métallique.

La couche mince polycristalline à base de silicium 11 présente une orientation préférentielle {100} et {111}.

La couche mince polycristalline à base de silicium 11 peut être déposée par épitaxie qui est un mécanisme connu de croissance cristalline avec arrangement des atomes. Le substrat métallique texturé cristallographiquement 1 est utilisé comme germe de croissance du film mince 11 au fur et à mesure de l'apport des atomes ou des nanocristaux de silicium. La croissance épitaxiale n'est en général possible que s'il y a accord de maille entre le système cristallin déposé (dans notre cas, le silicium) et celui du substrat 1 (dans notre cas, le substrat en alliage fer-nickel). Les conditions usuelles d'épitaxie sont : même système cristallin (dans notre cas, le système cubique faces centrées du silicium) et paramètres de maille très voisins. Le désaccord D entre les paramètres de maille, défini par l'expression suivante, doit être inférieur à 3% :

$$D = 100 \times (a_{substrat} - a_{silicium})/a_{silicium} \; ;$$

où a est le paramètre de maille.

En présence d'épitaxie, la texture cristallographique du film mince 11 est approximativement identique à celle du substrat métallique texturé cristallographiquement 1. Selon l'art antérieur, l'épitaxie était réalisée à haute température. Nous verrons plus loin que le procédé de dépôt de silicium, selon l'invention, permet de réaliser une épitaxie à 200 °C.

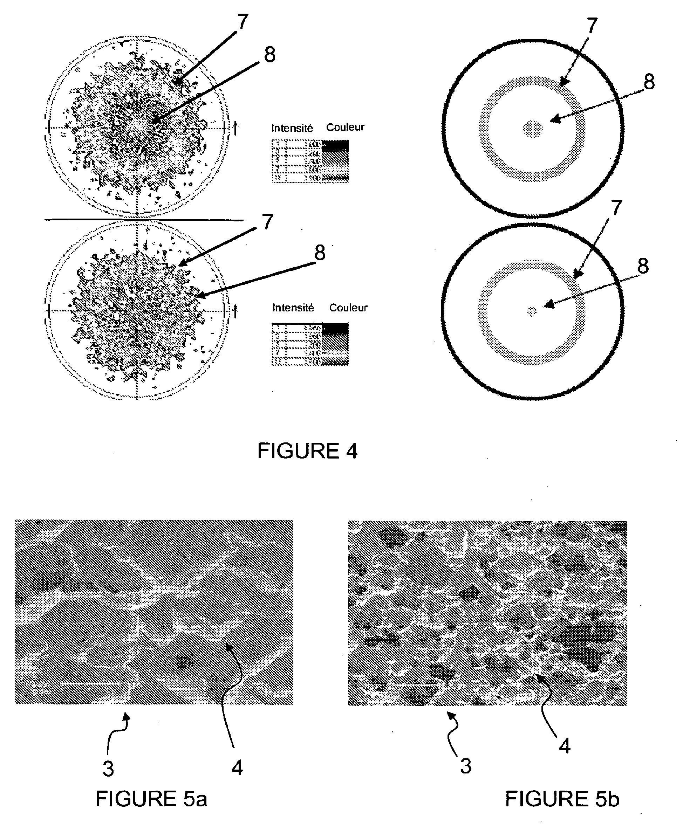

Si l'écart des paramètres de maille est supérieur à 3% mais inférieur à 20%, il peut y avoir croissance orientée du film mince 11. Dans ce cas, les grains du film mince 11 présentent un plan cristallographique (hkl) parallèle à la surface du substrat métallique texture cristallographiquement 1. Les grains du film mince 11 étant désorientés dans le plan du substrat 1, la figure de pôles représentant la texture cristallographique du film mince est alors un anneau, comme le montre la figure 4. La couche mince est dite avoir une orientation {hkl}.

La figure 4 représente les figures de pôles {111} de films minces de silicium polycristallin 11 obtenus selon deux modes de réalisation de l'invention.

La figure de pôles {111} en haut de la figure correspond à un substrat métallique texturé cristallographiquement 1 n'ayant pas subi de gravure chimique.

La figure de pôles {111} en bas de la figure correspond à un substrat métallique texturé cristallographiquement 1 ayant subi une gravure chimique, comme décrite plus loin.

Les figures de pôles {111} révèlent la présence d'un film mince de silicium texturé. Les anneaux 7, 8 (le premier 8 au centre en $\psi$ = 0°, le deuxième 7 en $\psi$ = 54,8°) traduisent une orientation préférentielle des grains de silicium caractérisée par les directions <111> et <100> perpendiculaires ou les plans (111) et (100) parallèles à la surface du substrat métallique texturé cristallographiquement 1. Les grains sont désorientés dans le plan du substrat métallique texturé cristallographiquement 1.

Le dépôt sur un substrat métallique texturé cristallographiquement 1 n'ayant pas subi de gravure chimique favorise les orientations {111} et {100}. Le dépôt sur un substrat métallique texturé cristallographiquement 1 ayant subi une gravure chimique favorise l'orientation {100}.

Pour obtenir de tels résultats, le substrat 1 en alliage fer-nickel doit présenter les deux caractéristiques suivantes :

- Un système cristallin cubique à faces centrées ;
- Un désaccord limité, D < 20% ;

Il est possible d'obtenir des couches minces polycristallines à base de silicium 11 ayant une fraction volumique de silicium de 58% en volume pour des grains de taille inférieure à 0,1 $\mu$m et une fraction volumique de silicium de 42% pour des tailles de grains comprises entre 0,1 $\mu$m et 1 $\mu$m.

Le tableau suivant donne quelques exemples de paramètres pour des couches minces 11 obtenues avec différents substrats métalliques texturés cristallographiquement 1.

| Alliage | Numérotation des films minces | Anisotropie Cristalline | | Rugosité $R_a$(nm) |
|---------|---------|---------|---------|---------|
| | | Intensité : R | Désorientation : $(\delta\phi + \delta\varphi)/2$ | |
| Fe-41 Ni | 1 | 18,5 | 11,7 | 21 |
| | 2 | | | |
| Fe-41Ni | 3 | Isotrope | | 100 |
| Fe-41Ni | 4 | Isotrope | | 20 |
| Fe-48Ni | 5 | 20,5 | 11,2 | 100 |
| Ni-4W | 6 | 8 | 30 | 100 |
| Fe-33Ni-2Cr-3Cu | 7 | 11 | 15 | 100 |

De bons résultats sont obtenus pour la couche mince n°1 qui présente une rugosité $R_a$ de 21 nm, un ratio R de 18,5 et une désorientation de 11,7°.

L'alliage constituant le substrat métallique texturé cristallographiquement 1 doit présenter un coefficient de dilatation proche de celui du silicium, entre - 25°C et +150°C.

L'épaisseur du substrat 1 en alliage est de l'ordre de 100 $\mu$m alors que celle du film mince 11 est inférieure à 5 $\mu$m. Le substrat 1 impose donc au silicium ses variations de longueurs dues à la dilatation thermique. Si aucune précaution n'est prise pour adapter le coefficient de dilatation du substrat 1 à celui du silicium, le film mince 11 peut subir deux types d'endommagements dégradant les propriétés optoélectroniques : une décohésion du film mince 11 pouvant générer un pelage du dépôt de silicium, des fissurations du film mince 11 lorsque le substrat 1 le soumet à des contraintes de traction et l'apparition de dislocations dans la couche mince de silicium 11.

Les couches minces de silicium 11 sont déposées à des températures supérieures à 100°C. En outre la température de fonctionnement des cellules ou modules photovoltaïques est comprise entre -50°C et +100°C. Il est par conséquent recommandé que le coefficient moyen de dilatation du substrat 1 soit supérieur ou égal à celui du silicium ($\alpha_{Si} \sim 2.6 \ 10^{-6} \ K^{-1}$) de façon à conserver la couche mince 11 en compression pendant son utilisation.

Le coefficient moyen de dilatation $\alpha_{20}^{100}$ du substrat 1 d'alliage entre 20°C et 100°C doit être supérieur à $10^{-6}$ $K^{-1}$, et de préférence compris entre $10^{-6}$ $K^{-1}$ et $10 \ 10^{-6}$ $K^{-1}$.

La couche mince polycristalline à base de silicium 11 présente une épaisseur inférieure à 5 $\mu$m, de préférence comprise entre 2 à 3 $\mu$m, et comprend des cristaux de silicium de dimension comprise entre 0,1 $\mu$m et 2 $\mu$m.

Selon un autre mode de réalisation possible de l'invention, la surface 3 du substrat métallique texturé cristallographiquement 1, destinée à accueillir un dépôt de couche mince, peut subir une gravure chimique avant l'étape de dépôt de la couche mince polycristalline à base de silicium 11.

La texture cristallographique cube du substrat métallique texturé cristallographiquement 1 offre une structure comparable à celle d'un monocristal. Les grains dont la taille est proche de 10 $\mu$m (GASTM = 10) sont approximativement tous orientés de façon similaire puisque la désorientation recherchée entre les grains est inférieure à 20°.

Cette texture cristallographique cube caractérisée par la famille de plans {100} parallèles à la surface 3 destinée à accueillir un dépôt de couche mince, et la direction <001> parallèle à la direction de laminage est propice à la fabrication de figures d'attaques chimiques orientées comme le montrent les observations réalisées au microscope électronique à balayage, représentées sur les figures 5a et 5b à des grandissements différents, et obtenues sur un substrat métallique texturé cristallographiquement 1 comprenant un alliage fer-nickel contenant 41% de nickel. La figure 5a, située à gauche, représente un agrandissement de la figure 5b.

Le procédé de gravure chimique permet d'améliorer les performances des cellules photovoltaïques en couche mince en augmentant les possibilités de piégeage de la lumière dans les couches de silicium (« light trapping »).

Il est alors possible de contrôler la réflexion de la lumière sur la face arrière métallique en alliage fer-nickel en utilisant la symétrie particulière de la texture cristallographique cube et l'aptitude du substrat métallique 1 à être gravé par attaque chimique sélective des plans cristallographiques : la cinétique d'attaque chimique des plans {100} est plus élevée que celle des plans {111}.

La gravure peut être réalisée au trempé, par passage du substrat métallique 1 entre deux rouleaux pendant une durée comprise entre 0,1 et 1 mn, dans un bain thermostaté entre 15°C et 35°C et contenant par exemple une solution de divers chlorures :

-    0,1 % de chlorure de lithium ;

- 0,1 % de chlorure de tétraméthylammonium ;
- 2% de triéthanolamine.

En fin de gravure, le substrat métallique 1 est rincé abondamment dans plusieurs bains et séché à une température comprise entre 100°C et 200°C, toujours selon un procédé au défilé. Il est important d'avoir rincé suffisamment la surface 3 du substrat 1 afin d'éviter toute corrosion par les chlorures. Le substrat métallique 1 peut être huilé, dans ce cas il devra être dégraissé avant le dépôt du film mince 11.

Compte tenu de l'orientation des grains texturés 4, le résultat est une surface 3 de substrat constituée de pyramides inversées, comme représenté sur la figure 6, de quelques microns de hauteur, sur laquelle on peut construire une cellule photovoltaïque constituée d'une couche de silicium cristallin 11. La surface de la cellule photovoltaïque 9 est également représentée sur la figure 6.

On obtient alors un genre de réseau composé des plans cristallins attaqué préférentiellement. La surface 3 présente des plans {111}, ce qui génère des genres de cônes en surface. Les grains 4 sont en forme de pyramide présentant des plans {111} et comprenant des marches 12 selon les plans {100} de façon à former un réseau du type réseau blazé (« blazed grating »).

Deux effets se conjuguent. Premièrement, la réflexion sur les bords des cavités pyramidales 10 qui contribue à modifier le libre parcours moyen de la lumière dans la couche de silicium 11. Un rayon lumineux frappant orthogonalement la cellule photovoltaïque aura tendance à se réfléchir et à rester piégé dans la couche de silicium 11.

Deuxièmement, la diffraction sur les bords des trous qui représentent des petites marches 12 résultant de la gravure différentielle. On a alors une diffraction de la lumière du type réseau blazé. Ce réseau favorise la réflexion de la lumière dans les ordres d'interférence supérieurs, correspondant à une forte inclinaison des rayons lumineux, plutôt qu'une réflexion orthogonale des rayons lumineux.

Comme le montre la figure 7, les cavités pyramidales 10 sont réparties comme les grains d'alliage 4 et donc de manière aléatoire, ce qui améliore la distribution de la lumière dans la couche mince de silicium 11.

Le phénomène de réseau blazé tend à maintenir les fortes longueurs d'onde dans la couche de silicium 11.

Cette technique permet de faire diffracter les photons sur la surface du réseau ainsi créé et de les piéger dans les couches de silicium 11.

La structuration de la surface de la couche de silicium 11 permet d'atténuer la réflectivité du substrat métallique texturé cristallographiquement 1.

L'invention concerne également une cellule photovoltaïque comprenant un dispositif texturé cristallographiquement 1 tel que décrit précédemment.

Selon un mode de réalisation possible de l'invention, la cellule photovoltaïque comprend un dispositif texturé cristallographiquement 13 dans lequel le substrat métallique texturé cristallographiquement 1 présente une teneur en nickel égale à 41% en poids par rapport au poids total de l'alliage constituant le substrat métallique. Le silicium de la couche mince de silicium polycristallin 11 peut être dopé. Il peut être dopé P ou N, soit au phosphore ou soit au bore, selon le type de diode désirée (PIN ou NIP).

La cellule photovoltaïque comprend également une couche mince de silicium intrinsèque polycristallin 14, non dopée, déposée sur le dispositif texturé cristallographiquement 13, une couche mince de silicium polycristallin dopé 15, déposée sur la couche mince de silicium intrinsèque polycristallin 14, une couche mince d'un oxyde transparent conducteur 16 déposée sur la couche mince de silicium polycristallin dopé au bore 15, et une grille métallique 17 disposée sur la couche mince d'un oxyde transparent conducteur 16 et comprenant plusieurs éléments dont un élément de grille central 18.

Le silicium de la couche mince de silicium polycristallin dopé 15 peut être dopé N ou P, soit au phosphore ou soit au bore, selon le type de diode désirée (PIN ou NIP).

La couche mince d'un oxyde transparent conducteur 16 peut être une couche d'oxyde d'indium-étain (ITO), de ZnO ou $SnO_2$, par exemple.

Les couches dopées sont très fines par rapport à l'épaisseur de la couche mince de silicium intrinsèque polycristallin 14.

Le silicium de la couche de silicium 11 est massivement cristallin, la part de silicium amorphe est inférieure à 1%. De plus, le silicium a une orientation préférentielle: les grains sont orientés avec leur plan {111} et {100} parallèles aux plans de l'alliage fer-nickel fortement texturé.

Un mode d'assemblage possible consiste à découper des plaquettes de cellule photovoltaïque, par exemple carrées et de connecter la surface supérieure sur la surface inférieure de la cellule photovoltaïque suivante en utilisant des méplats de cuivre.

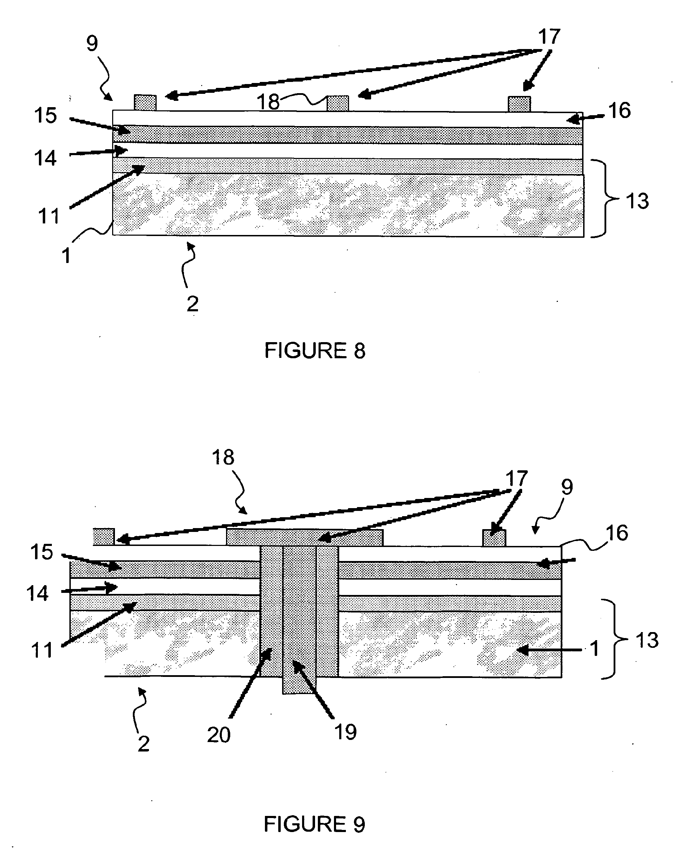

Selon un autre mode de réalisation possible de l'invention, le dispositif texturé cristallographiquement 13 et les différentes couches minces 14 à 16 de la cellule photovoltaïque sont traversés par un connecteur 19, comme représenté sur la figure 9. Le connecteur 19 est relié à l'élément de grille central 18 et débouche à l'extérieur de la cellule photovoltaïque à travers la surface de connexion 2 du substrat métallique texturé cristallographiquement 1.

Le connecteur 19 est entouré d'un isolant 20 s'étendant depuis la surface de connexion 2 du substrat métallique texturé cristallographiquement 1 jusqu'à l'élément de grille central 18.

Une telle cellule photovoltaïque est appelée cellule photovoltaïque à contact arrière. Les deux connexions sont situées du même côté de la cellule photovoltaïque, c'est-à-dire du côté de la face arrière de la cellule photovoltaïque et plus précisément du côté de la surface de connexion 2 du substrat métallique texturé cristallographiquement 1. Le substrat métallique texturé cristallographiquement 1 est connecté négativement (connexion négative) et le connecteur 19 est connecté positivement (connexion positive).

Il est possible de procéder selon le procédé de fabrication qui suit et qui comprend une étape de laminage et texturation de l'alliage fer-nickel.

Le procédé de fabrication comprend également une étape de gravure chimique de trous dans la surface du substrat métallique texturé cristallographiquement 1. On protège les zones qui ne doivent pas être gravée. La technique utilisable est celle employée pour fabriquer des "shadow-masks" de tubes à rayons cathodiques.

Une autre étape consiste à nettoyer la surface texturée non gravée par les techniques connues.

Puis, du silicium est déposé selon la méthode décrite ci-dessus et on fabrique une surface photovoltaïque.

Les trous qui contiennent aussi des couches de silicium sont ensuite nettoyés par sablage: il suffit de retourner le substrat métallique texturé cristallographiquement 1 et de graver en utilisant le substrat métallique texturé cristallographiquement 1 comme masque.

Les trous sont isolés, il suffit de sérigraphier la face arrière de la cellule photovoltaïque sans dépôt de silicium à l'aide d'un polymère fragile (qui pourra être sablé).

Et puis, à l'aide d'une buse, on sable un trou dans la zone isolante.

On sérigraphie un conducteur sur la couche mince d'oxyde d'indium-étain 16 qui remplira les trous et renverra, en face arrière de la cellule photovoltaïque, les électrons collectés par la couche mince d'oxyde d'indium-étain 16.

Les zones de découpe du métal sont sablées.

Puis, le métal est découpé par des techniques conventionnelles. On obtient alors des cellules photovoltaïques de silicium à contact arrière qui peuvent être utilisées comme les wafers conventionnels pour la fabrication de modules photovoltaïques.

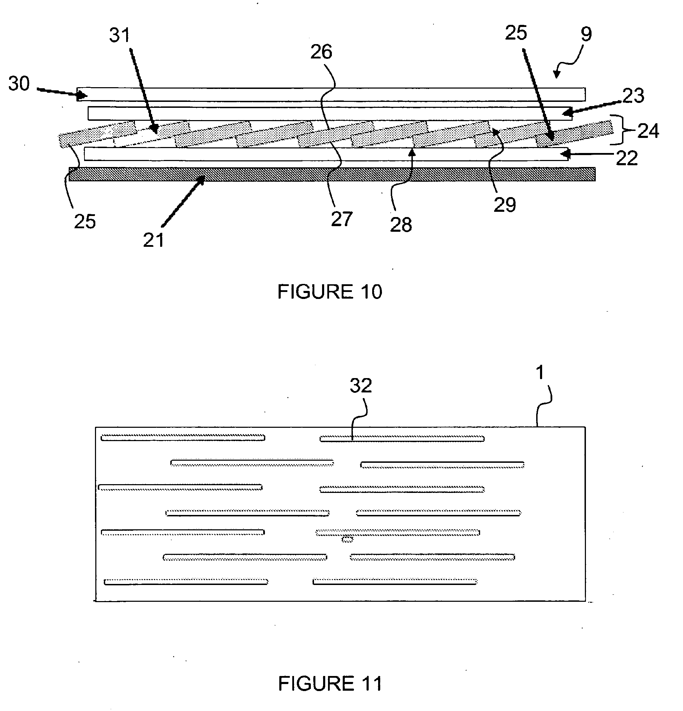

L'invention concerne également un module photovoltaïque comprenant une série de cellules photovoltaïques 31 se présentant chacune sous la forme d'une bande de dimension de l'ordre de 20 mm de large, comme représenté sur la figure 10.

Les cellules photovoltaïques de l'art antérieur comprennent des substrats en forme de bandes de grande largeur, qui sont en général des plaquettes de 15x15 cm.

Pour obtenir des sources d'énergie conformes aux besoins, il faut concevoir une structure générant une différence de potentiel de plusieurs volts, par exemple de 12 volts.

Or la tension de circuit ouvert de la diode silicium est de l'ordre de 0,5 volt. Une solution consiste à mettre en série plusieurs bandes de cellules photovoltaïques 31 pour atteindre la tension donnée.

Le module photovoltaïque formé de cellules photovoltaïques sous forme de bande 31 comprend une couche mince de polymère 21 et deux couches minces de colle thermoréactivable (EVA) 22, 23, dont une première 22 et une deuxième 23 couches minces de colle thermoréactivable. La première couche mince de colle thermoréactivable 22 est déposée sur la couche mince de polymère 21.

Le module photovoltaïque comprend également une couche conductrice 24 formée d'une pluralité de cellules photovoltaïques sous forme de bande 31, et de deux bandes de cuivre 25 disposées aux extrémités respectives de la couche conductrice 24.

Les cellules photovoltaïques sous forme de bande 31 et les deux bandes de cuivre 25 sont disposées entre les première 22 et deuxième 23 couches minces de colle thermoréactivable, parallèlement les unes par rapport aux autres, inclinées par rapport aux couches minces de colle thermoréactivable 22, 23 et en se chevauchant de façon à former une rangée selon une direction parallèle aux couches minces de colle thermoréactivable 22, 23.

La pluralité de cellules photovoltaïques sous forme de bande 31 et les deux bandes de cuivre 25 forment une connexion en série.

Chaque cellule photovoltaïque sous forme de bande 31 est en contact au voisinage de chacune de ses extrémités respectives avec une autre cellule photovoltaïque sous forme de bande 31, sauf les deux cellules photovoltaïques sous forme de bande 31 situées à l'extrémité de la couche conductrice 24 qui sont chacune en contact avec une seule cellule photovoltaïque sous forme de bande 31 au voisinage de l'une de leurs extrémités et avec une bande de cuivre 25 au voisinage de l'autre de leurs extrémités.

La série de bandes de cellules photovoltaïques sous forme de bande 31 et les deux bandes de cuivre 25 sont disposés de façon à former comme une succession de « dominos » renversés. Chaque cellule photovoltaïque sous forme de bande 31 comprend une face avant 26 et une face arrière 27, ainsi des première 28, et deuxième 29 extrémités.

Chaque face arrière 27 d'une cellule photovoltaïque sous forme de bande 31 est en contact avec la première couche mince de colle thermoréactivable 22, à proximité de sa première extrémité 28.

Chaque face arrière 27 d'une cellule photovoltaïque sous forme de bande 31 est en contact avec une autre cellule photovoltaïque sous forme de bande 31, à proximité de sa deuxième extrémité 29.

Chaque face avant 26 d'une cellule photovoltaïque sous forme de bande 31 est en contact avec une autre cellule photovoltaïque sous forme de bande 31, à proximité de sa première extrémité 28.

Chaque face avant 26 d'une cellule photovoltaïque sous forme de bande 31 est en contact également avec la deuxième couche mince de colle thermoréactivable 23, à proximité de sa deuxième extrémité 29.

Les deux bandes de cuivre 25 disposées aux extrémités respectives de la couche conductrice 24 permettent au module photovoltaïque d'être connecté latéralement.

Le module photovoltaïque comprend également une couche mince de polyméthylméthacrylate (PMMA) 30 déposée sur la deuxième couche mince de colle thermoréactivable 23.

La couche mince d'oxyde d'indium-étain 16 des cellules photovoltaïques sous forme de bande 31 est transparente et conductrice.

Le procédé de fabrication du module photovoltaïque est décrit ci-dessous.

Une première couche de colle thermoréactivable (EVA) 16 est déposée sur la bande polymère 21.

Les cellules photovoltaïques sous forme de bande 31 sont déposées parallèlement sur la bande polymère 21 qui assure l'isolation électrique. La bande polymère 21 peut être du polyimide ou du polyméthylméthacrylate (PMMA), par exemple.

Les cellules photovoltaïques sous forme de bande 31 sont mises en recouvrement sur une distance de 5 mm environ. Les contacts réalisés ainsi mettent les cellules photovoltaïques sous forme de bande 31 en connexion série.

Les deux bandes de cuivre 25 sont disposées aux extrémités de la couche conductrice 24 en recouvrement.

La deuxième couche mince de colle thermoréactivable (EVA) 23 est disposée sur la surface de la couche conductrice 24.

La couche mince de polyméthylméthacrylate (PMMA) 30 est ensuite appliquée sur la surface de la deuxième couche mince de colle thermoréactivable (EVA) 23.

L'ensemble est enfin solidarisé par pressage à chaud (lamination).

On obtient ainsi un module photovoltaïque dont la différence de potentiel dépend du nombre de cellules photovoltaïques sous forme de bande 31 juxtaposées.

Le procédé de fabrication des modules photovoltaïques comprend une étape de découpe de bandes de dispositif texturé cristallographiquement 13 pour obtenir des bandes de dispositif texturé cristallographiquement 13 de plus petites dimensions. Cette étape de découpe sur le rouleau d'alliage intervient après le dépôt des différentes couches minces. Les bandes de dispositif texturé cristallographiquement 13 sont découpées à la taille voulue, selon les applications.

Pour découper les dispositifs texturés cristallographiquement 13, il faut éviter de fissurer le silicium. Et donc préalablement, il faut créer un sillon sur le substrat métallique texturé cristallographiquement 1 qui est revêtu de silicium. Le sillon est crée en utilisant une technique de micro sablage: des fines particules d'alumine sont projetées a l'aide d'une buse sur la surface de silicium.

Il est ainsi possible de réaliser un sillon exempt de silicium sur la surface 3 du substrat métallique texturé cristallographiquement 1, et ayant une largeur bien contrôlée, comme par exemple une largeur de 2 mm.

Il est ensuite possible de découper les bandes de dispositif texturé cristallographiquement 13 avec des outils conventionnels, par exemple des cisailles rotatives, en prenant la précaution de protéger la surface des cylindres avec une bande d'élastomère.

Le procédé de découpe des dispositifs texturés cristallographiquement 13 peut être réalisé selon un autre mode de réalisation de l'invention.

Des sillons 32 sont gravés dans la bande de substrat métallique texturé cristallographiquement 1 pour faciliter une découpe ultérieure, comme représenté sur la figure 11.

Après dépôt de silicium sur le substrat métallique texturé cristallographiquement 1, les sillons 32 sont sablés pour éliminer les courts-circuits. Les attaches sont ensuite découpées.

L'invention concerne également un procédé de dépôt de couches minces à base de silicium sur un substrat métallique texturé cristallographiquement 1, tel que décrit précédemment.

Selon un mode de réalisation de l'invention, le dépôt de couches minces polycristalline à base de silicium est réalisé par une méthode de dépôt chimique en phase vapeur (CVD) et avantageusement par une méthode de dépôt chimique en phase vapeur assisté par plasma radiofréquence (RFPECVD), la fréquence appliquée au plasma étant de 13,56 MHz. Selon deux modes de réalisation différents, le dépôt peut être réalisé sur un substrat métallique texturé cristallographiquement 1 ayant subi une gravure chimique ou sans gravure chimique.

La température du plasma doit être inférieure à 300°C, de préférence de l'ordre de 200°C. Le plasma comprend avantageusement un mélange gazeux de tétrafluorure de silicium ($SiF_4$), d'hydrogène et d'argon. Il est également possible de remplacer le tétrafluorure de silicium par du silane ($SiH_4$).

La croissance orientée ou épitaxiale de couches minces de silicium polycristallin 11 sur alliage fer-nickel est favorisée par la texture cristallographique de l'alliage et par les conditions du plasma

Comme exemple de réalisation, les meilleurs résultats sont obtenus par dépôt à partir de la dissociation de mélanges gazeux de SiF4, d'hydrogène et d'argon, avec des débits de gaz en centimètres cubiques par minute de (1,2,40) (sccm), sous une pression totale de 1800 mTorr, une puissance radiofréquence de 16 W et une température de substrat 1 d'environ 200 °C. La température de substrat 1 doit être inférieure à 300 °C.

Le résultat est l'obtention d'une couche mince de silicium 11 complètement cristallisée par dépôt direct à basse température (200 °C) sur un substrat 1 formé d'un alliage fer-nickel comprenant 41 % de nickel.

La quantification des fractions cristallines peut être obtenue par des mesures d'ellipsométrie spectroscopique.

L'analyse des mesures d'ellipsométrie spectroscopique à l'aide d'un modèle optique permet de quantifier la fraction cristalline ainsi que de distinguer entre gros grains (tailles entre 0,1 $\mu$m et 1 $\mu$m) et petit grains (< 0,1 $\mu$m), comme décrit dans le document « A. Abramov, Y. Djeridane, R. Vanderhaghen, and P. Roca i Cabarrocas: "Large grain $\mu$c-Si:H films deposited at low temperature: growth process and electronic properties". J. Non Cryst. Solids 352 (2006) pp. 964-967».

Le tableau 2 donne les fractions cristallines d'une couche de silicium polycristallin ainsi que de la couche de rugosité (6 nm) pour une couche mince polycristalline à base de silicium 11, obtenue à l'aide des mesures d'ellipsomètrie spectroscopique.

| Epaisseur (nm) | Fraction petit grain | Fraction gros grain | Fraction de vide |
|---|---|---|---|
| 6 | 38 | 35 | 27 |
| 379 | 57 | 38 | 5 |

Les résultats du modèle optique permettant de reproduire les mesures d'ellipsomètrie montrent que la couche de silicium 11 qui a une épaisseur de 379 nm comprend un mélange de 57% de petits cristaux, 38% de gros cristaux et 5% de vide (ce dernier étant associé à l'hydrogène incorporé dans la couche et une faible porosité probablement aux joints de grains).

Pour faire varier ces paramètres, il est possible de faire varier les conditions opératoires : mélange des gaz, pression, puissance radiofréquence et température du substrat.

Les gaz sources sont le SiF4, l'hydrogène et pour les gaz dopants le triméthylbore et la phosphine. Dans le plasma 33, les collisions inélastiques entre les électrons énergétiques (accélérés par le champ électrique radiofréquence) et le silane génèrent des radicaux, des ions et des espèces excitées. Les espèces réactives produites dans le plasma 33 vont se condenser sur le substrat 1 pour former (atome après atome) une couche mince en général désordonnée.

Cette technique permet le dépôt de couches minces à base de silicium 11 à basse température (typiquement entre 100°C et 300°C), sur des substrats 1 de grandes surfaces (pouvant atteindre 5 m$^2$).

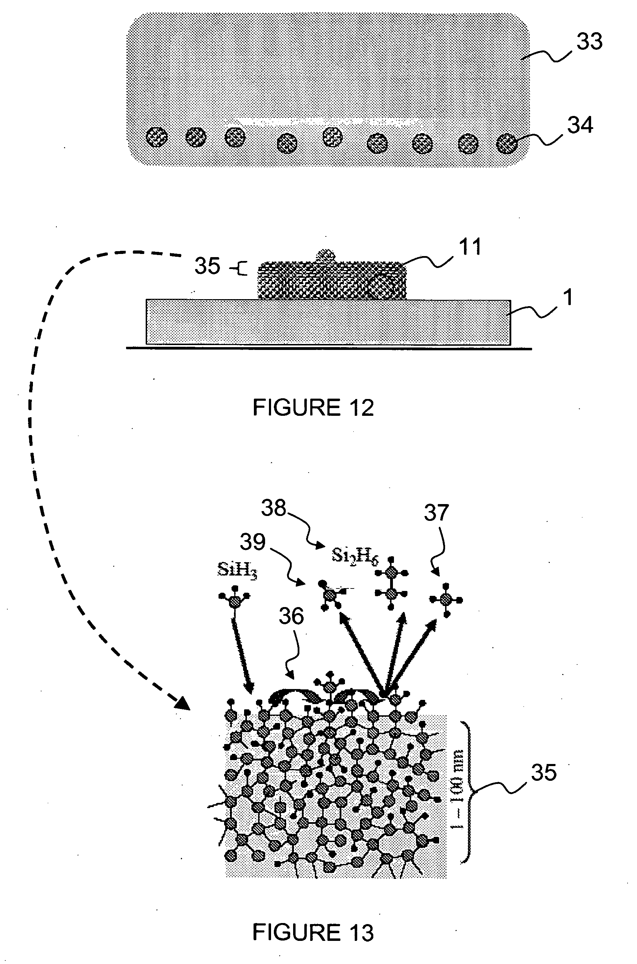

La figure 12 représente un mode opératoire de dépôt de couches minces à base de silicium 11 sur un substrat métallique texturé cristallographiquement 1, par décomposition chimique des gaz réactifs dans un plasma 33 de décharge à basse température.

La figure 13 représente un agrandissement de la zone de croissance 35 du silicium sur la couche mince polycristalline 11 pendant le mode opératoire représenté sur la figure 12. Cet exemple correspond à la croissance à partir de silane (radicaux SiH$_3$).

Les produits de dissociation des gaz précurseurs 34 "condensent" sur le substrat métallique texturé cristallographiquement 1 formant une couche mince minces à base de silicium 11. Les produits de dissociation des gaz précurseurs 34 sont des nanocristaux qui peuvent être utilisés comme briques élémentaires pour la croissance de la couche de silicium polycristallin. L'interface plasma/solide se fait sur une épaisseur de matériau appelée zone de croissance 35 et implique des réactions contrôlées par la température du substrat métallique texturé cristallographiquement 1 et l'énergie apportée par les ions et par l'hydrogène atomique (recuit chimique). A l'interface plasma/solide, il se produit des phénomènes de physisorption 36, d'abstraction d'hydrogène 37, de recombinaison (Si$_2$H$_6$) 38 et de désorption 39.

Il est également possible d'optimiser les procédés de dépôt pour synthétiser des nanocristaux de silicium 34 dans les plasmas de silane (SiH$_4$) et de tétrafluorure de silicium (SiF$_4$), comme décrit dans le document « P. Roca i Cabarrocas, Th Nguyen-Tran, Y. Djeridane, A. Abramov, E. Johnson and G. Patriarche: "Synthesis of silicon nanocrystals in silane plasmas for nanoelectronics and large area electronic devices". J. Phys. D: Appl. Phys. 40 (2007) pp. 2258-2266 ».

Il est également possible d'utiliser d'autres techniques de dépôt CVD, comme par exemple la CVD plasma micro-ondes ou la CVD assistée par filament chaud (HWCVD), dans le but d'augmenter la vitesse de dépôt ou de diminuer la densité des défauts dans la couche intrinsèque (non dopée intentionnellement).

Le procédé de dépôt selon l'invention permet d'obtenir une couche mince polycristalline à base de silicium 11 sans aucune pollution du silicium par le substrat métallique texturé cristallographiquement 1. Les rendements de conversion sont également améliorés.

Ainsi, selon l'invention, le substrat métallique texturé cristallographiquement 1 permet de favoriser les mécanismes de croissance épitaxiale ou orientée à gros grains du silicium, directement pendant les phases de dépôts.

Le fait que le coefficient moyen de dilatation de l'alliage fer-nickel soit légèrement supérieur ou égal à celui du film mince polycristallin à base de silicium 11 permet de limiter les contraintes thermiques générées sur la couche mince polycristalline à base de silicium 11 en fonctionnement et d'augmenter la durée de vie des cellules photovoltaïques.

## Revendications

**1.** Substrat métallique texturé cristallographiquement (1) comprenant une surface de connexion (2) et une surface (3) destinée à accueillir un dépôt de couche mince, ledit substrat métallique texturé cristallographiquement (1) étant constitué d'un alliage présentant un système cristallin cubique à faces centrées et une texture cristallographique cube {100} <001> majoritaire, la surface destinée à accueillir le dépôt de couche mince (3) comprenant des grains (4) présentant majoritairement des plans cristallographiques {100} parallèles à la surface (3) destinée à accueillir un dépôt de couche mince,
**caractérisé en ce que** :

- l'alliage est un alliage fer-nickel ayant une composition comprenant, en % en poids par rapport au poids total dudit alliage :

Ni $\geq$ 30 %,
Cu $\leq$ 15 %,
Cr $\leq$ 15 %,
Co $\leq$ 12 %,
Mn $\leq$ 5 %,
S < 0,0007 %,
P < 0,003 %,
B < 0,0005 %,
Pb < 0,0001 %,

- les pourcentages en nickel, chrome, cuivre, cobalt et manganèse sont tels que l'alliage satisfait la condition suivante :

34 % $\leq$ (Ni + Cr + Cu/2 + Co/2 + Mn), et

- l'alliage comprend jusqu'à 1% en poids d'un ou plusieurs éléments désoxydants choisis parmi le silicium, le magnésium, l'aluminium et le calcium, le reste des éléments constituant l'alliage étant du fer et des impuretés.

**2.** Substrat métallique texturé cristallographiquement selon la revendication 1, **caractérisé en ce que** les pourcentages en nickel, chrome, cuivre, cobalt et manganèse sont tels que l'alliage satisfait la condition suivante :

34 % $\leq$ (Ni + Cr + Cu/2 + Co/2 + Mn) $\leq$ 54 %,

- le coefficient moyen de dilatation de l'alliage, $\alpha_{20}^{100}$, entre 20°C et 100°C, étant supérieur à $10^{-6}K^{-1}$, et de préférence compris entre $10^{-6}$ $K^{-1}$ et 10 $10^{-6}$ $K^{-1}$.

**3.** Substrat métallique texturé cristallographiquement selon l'une quelconque des revendications 1 ou 2, **caractérisé en ce que** la surface (3) destinée à accueillir un dépôt de couche mince du substrat métallique texturé cristallographiquement (1) présente une rugosité $R_a$ inférieure à 150 nm, et de préférence inférieure à 50 nm.

**4.** Substrat métallique texturé cristallographiquement selon l'une quelconque des revendications 1 à 3, **caractérisé en ce que** le substrat métallique texturé cristallographiquement (1) est mince avec une épaisseur comprise entre 0,5 mm et 0,05 mm, de préférence de l'ordre de 0,1 mm.

**5.** Substrat métallique texturé cristallographiquement selon l'une quelconque des revendications 1 à 4, **caractérisé en ce que** les grains (4) sur la surface (3) destinée à accueillir un dépôt de couche mince sont gravés en forme de pyramide présentant des plans {111} et des marches (12) selon les plans {100} de façon à former un réseau de type réseau blazé.

**6.** Dispositif texturé cristallographiquement **caractérisé en ce qu'**il comprend un substrat métallique texturé cristallographiquement (1), tel que défini selon l'une quelconque des revendications 1 à 5, sur lequel a été déposée une couche mince polycristalline à base de silicium (11), la couche mince polycristalline (11) présentant une orientation cristallographique préférentielle {100} et {111}.

**7.** Dispositif texturé cristallographiquement selon la revendication 6, **caractérisé en ce que** le paramètre de maille cristalline du substrat métallique texturé cristallographiquement (1) est identique ou presque à celui de la couche mince polycristalline à base de silicium (11).

**8.** Dispositif texturé cristallographiquement selon l'une quelconque des revendications 6 ou 7, **caractérisé en ce que** le coefficient moyen de dilatation de l'alliage constituant le substrat métallique texturé cristallographiquement (1) est proche de celui de la couche mince polycristalline (11).

**9.** Dispositif texturé cristallographiquement selon l'une quelconque des revendications 6 à 8, **caractérisé en ce que** la couche mince polycristalline (11) à base de silicium présente une épaisseur inférieure à 10 $\mu$m, de préférence inférieure à 5 $\mu$m, et comprend des cristaux de silicium de dimension comprise entre 0,1 $\mu$m et 2 $\mu$m.

**10.** Cellule photovoltaïque **caractérisée en ce qu'**elle comprend un dispositif texturé cristallographiquement (13) tel que défini selon l'une quelconque des revendications 6 à 9.

**11.** Cellule photovoltaïque selon la revendication 10 **caractérisée en ce qu'**elle comprend :

- un dispositif texturé cristallographiquement (13) dans lequel :

   • le substrat métallique texturé cristallographiquement (1) présente une teneur en nickel égale à 41 % en poids par rapport au poids total de l'alliage constituant le substrat métallique (1),
   • le silicium de la couche mince de silicium polycristallin (11) est dopé,

- une couche mince de silicium intrinsèque polycristallin (14) déposée sur le dispositif texturé cristallographiquement (13),
- une couche mince de silicium polycristallin dopé (15), déposée sur la couche mince de silicium intrinsèque polycristallin (14),
- une couche mince d'un oxyde transparent conducteur (16) déposée sur la couche mince de silicium polycristallin dopé (15), et
- une grille métallique (17) disposée sur la couche mince d'oxyde transparent conducteur (16) et comprenant plusieurs éléments dont un élément de grille central (18).

**12.** Cellule photovoltaïque selon la revendication 11 **caractérisée en ce que** le dispositif texturé cristallographiquement (13) et les différentes couches minces (14, 15, 16) sont traversés par un connecteur (19) relié à l'élément de grille central (18) et débouchant à l'extérieur de la cellule photovoltaïque à travers la surface de connexion (2) du substrat métallique texturé cristallographiquement (1), ledit connecteur (19) étant entouré d'un isolant (20) s'étendant depuis la surface de connexion (2) du substrat métallique texturé cristallographiquement (1) jusqu'à l'élément de grille central (18).

**13.** Module photovoltaïque **caractérisé en ce qu'**il comprend :

- une couche mince de polymère (21),
- deux couches minces de colle thermoréactivable (22, 23), dont une première (22) et une deuxième (23) couches minces de colle thermoréactivable, la première couche mince de colle thermoréactivable (22) étant déposée sur la couche mince de polymère (21),
- une couche conductrice (24) formée d'une pluralité de cellules photovoltaïques, telles que définies selon la revendication 12, et de deux bandes de cuivre (25) disposées aux extrémités respectives de la couche conductrice formée d'une pluralité de cellules photovoltaïques (31), lesdites cellules photovoltaïques (31) étant sous forme de bandes et les deux bandes de cuivre (25) étant disposées entre les première (22) et deuxième (23) couches minces de colle thermoréactivable, parallèlement les unes par rapport aux autres, inclinées par rapport aux couches minces de colle thermoréactivable (22, 23) et en se chevauchant de façon à former une rangée de cellules photovoltaïques (31) et de bandes de cuivre (25) en contact selon une direction parallèle aux couches minces de colle thermoréactivable (22, 23), la pluralité de cellules photovoltaïques (31) et les deux bandes de cuivre (25) formant une connexion en série, et

- une couche mince de polyméthylméthacrylate (30) déposée sur la deuxième couche mince de colle thermoréactivable (23).

14. Procédé de dépôt de couches minces à base de silicium sur un substrat métallique texturé cristallographiquement (1), tel que défini selon l'une quelconque des revendications 1 à 5, **caractérisé en ce qu'**il est réalisé par une méthode de dépôt chimique en phase vapeur (CVD), la température du plasma étant inférieure à 300°C, de préférence de l'ordre de 200°C.

15. Procédé de dépôt de couches minces à base de silicium selon la revendication 14 **caractérisé en ce que** la méthode de dépôt chimique en phase vapeur (CVD) est une méthode de dépôt chimique en phase vapeur assisté par plasma radiofréquence (RFPECVD), le plasma comprenant un mélange gazeux de $SiF_4$, d'hydrogène et d'argon, et la puissance radiofréquence utilisée étant de l'ordre de 16 W.

16. Procédé de dépôt de couches minces à base de silicium selon l'une quelconque des revendications 14 ou 15, **caractérisé en ce que** la croissance épitaxiale du silicium est obtenue à partir de nanocristaux de silicium synthétisés dans le plasma.

**Patentansprüche**

1. Metallsubstrat (1) mit kristallographischer Struktur, das eine Verbindungsfläche (2) und eine Fläche (3) umfasst, die vorgesehen ist, eine Abscheidung einer dünnen Schicht aufzunehmen, wobei das Metallsubstrat (1) mit kristallographischer Struktur aus einer Legierung gebildet ist, die ein flächenzentriertes kubisches Kristallsystem und eine überwiegend kubische kristallographische Struktur {100} <001> aufweist, wobei die zum Aufnehmen einer Abscheidung einer dünnen Schicht vorgesehene Fläche (3) Körner (4) umfasst, die überwiegend kristallographische Ebenen {100} parallel zur für die Aufnahme einer Abscheidung einer dünnen Schicht vorgesehenen Fläche (3) aufweisen, **dadurch gekennzeichnet, dass**:

- die Legierung eine Eisen-Nickel-Legierung ist, die eine Zusammensetzung in Gew.-% in Bezug auf das Gesamtgewicht der Legierung umfasst:

$Ni \geq 30\%$,
$Cu \leq 15\%$
$Cr \leq 15\%$,
$Co \leq 12\%$,
$Mn \leq 5\%$,
$S < 0,0007\%$,
$P < 0,003\%$,
$B < 0,0005\%$,
$Pb < 0,0001\%$,

- wobei die Prozentangaben an Nickel, Chrom, Kupfer, Kobalt und Mangan derart sind, dass die Legierung die folgende Bedingung erfüllt:

$34\% \leq (Ni+Cr+Cu/2+Co/2+Mn)$, und

- die Legierung bis 1 Gew.-% ein oder mehrere Deoxidationselemente umfasst, die ausgewählt sind aus Silizium, Magnesium, Aluminium und Kalzium, wobei der Rest der die Legierung bildenden Elemente Eisen und Verunreinigungen ist.

2. Metallsubstrat mit kristallographischer Struktur nach Anspruch 1, **dadurch gekennzeichnet, dass** die Prozentangaben an Nickel, Chrom, Kupfer, Kobalt und Mangan derart sind, dass die Legierung die folgende Bedingung erfüllt:

$34\% \leq (Ni+Cr+Cu/2+Co/2+Mn) \leq 54\%$,

- wobei der mittlere Ausdehnungskoeffizient der Legierung, $\alpha_{20}^{100}$, zwischen 20°C und 100°C größer als $10^{-6}K^{-1}$ ist und vorzugsweise zwischen $10^{-6}K^{-1}$ und $10 \cdot 10^{-6}K^{-1}$ liegt.

3. Metallsubstrat mit kristallographischer Struktur nach einem beliebigen der Ansprüche 1 oder 2, **dadurch gekennzeichnet, dass** die zur Aufnahme einer Abscheidung einer dünnen Schicht vorgesehene Fläche (3) des Metallsubstrats (1) mit kristallographischer Struktur eine Rauheit $R_a$ kleiner als 150 nm und vorzugsweise kleiner als 50 nm aufweist.

4. Metallsubstrat mit kristallographischer Struktur nach einem beliebigen der Ansprüche 1 bis 3, **dadurch gekennzeichnet, dass** das Metallsubstrat (1) mit kristallographischer Struktur dünn ist mit einer Dicke, die zwischen 0,5 mm und 0,05 mm, vorzugsweise in der Größenordnung von 0,1 mm liegt.

5. Metallsubstrat mit kristallographischer Struktur nach einem beliebigen der Ansprüche 1 bis 4, **dadurch gekennzeichnet, dass** die Körner (4) auf der zur Aufnahme einer Abscheidung einer dünnen Schicht vorgesehenen Fläche (3) in Pyramidenform strukturiert sind, die Ebenen {111} und Stufen (12) gemäß den {100} Ebenen aufweist, um ein Blazegitter zu bilden.

6. Vorrichtung mit kristallographischer Struktur, **dadurch gekennzeichnet, dass** sie ein Metallsubstrat (1) mit kristallographischer Struktur umfasst, wie es nach einem beliebigen der Ansprüche 1 bis 5 definiert ist, auf das eine polykristalline dünne Schicht (11) auf Siliziumbasis abgeschieden wurde, wobei die polykristalline dünne Schicht (11) eine bevorzugte kristallographische Orientierung {100} und {111} aufweist.

7. Vorrichtung mit kristallographischer Struktur nach Anspruch 6, **dadurch gekennzeichnet, dass** die Kristallgitterkonstante des Metallsubstrats (1) mit kristallographischer Struktur identisch oder fast identisch zu der der polykristallinen dünnen Schicht (11) auf Siliziumbasis ist.

8. Vorrichtung mit kristallographischer Struktur nach einem beliebigen der Ansprüche 6 oder 7, **dadurch gekennzeichnet, dass** der mittlere Ausdehnungskoeffizient der Legierung, die das Metallsubstrat (1) mit kristallographischer Struktur bildet, nahe dem der polykristallinen dünnen Schicht (11) liegt.

9. Vorrichtung mit kristallographischer Struktur nach einem beliebigen der Ansprüche 6 bis 8, **dadurch gekennzeichnet, dass** die polykristalline dünne Schicht (11) auf Siliziumbasis eine Dicke kleiner als 10 $\mu$m, vorzugsweise kleiner als 5 $\mu$m aufweist und Siliziumkristalle mit einer Abmessung umfasst, die zwischen 0,1 $\mu$m und 2 $\mu$m liegt.

10. Photovoltaische Zelle, **dadurch gekennzeichnet, dass** sie eine Vorrichtung (13) mit kristallographischer Struktur umfasst, wie sie nach einem der Ansprüche 6 bis 9 definiert ist.

11. Photovoltaische Zelle nach Anspruch 10, **dadurch gekennzeichnet, dass** sie umfasst:

    - eine Vorrichtung (13) mit kristallographischer Struktur, bei der:

        • das Metallsubstrat (1) mit kristallographischer Struktur einen Gehalt an Nickel gleich 41 Gew.-% in Bezug auf das Gesamtgewicht der das Metallsubstrat (1) bildenden Legierung aufweist
        • das Silizium der dünnen Schicht (11) aus polykristallinem Silizium dotiert ist,

    - eine dünne Schicht (14) aus polykristallinem intrinsischen Silizium, die auf der Vorrichtung (13) mit kristallographischer Struktur abgeschieden ist,
    - eine dünne Schicht (15) aus dotiertem polykristallinen Silizium, die auf der dünnen Schicht (14) aus polykristallinem intrinsischen Silizium abgeschieden ist,
    - eine dünne Schicht eines leitenden transparenten Oxids (16), die auf der dünnen Schicht (15) aus dotiertem polykristallinen Silizium abgeschieden ist, und
    - ein Metallgitter (17), das auf der dünnen Schicht aus leitendem transparenten Oxid (16) angeordnet ist und das mehrere Elemente umfasst, von denen eines ein zentrales Gitterelement (18) ist.

12. Photovoltaische Zelle nach Anspruch 11, **dadurch gekennzeichnet, dass** die Vorrichtung (13) mit kristallographischer Struktur und die verschiedenen dünnen Schichten (14, 15, 16) von einem Leiter (19) durchquert werden, der mit dem zentralen Gitterelement (18) verbunden ist und nach außen von der photovoltaischen Zelle gesehen durch die Verbindungsfläche (2) des Metallsubstrats (1) mit kristallographischer Struktur mündet, wobei der Leiter (19) von einer Isolierung (20) umgeben ist, die sich von der Verbindungsfläche (2) des Metallsubstrats (1) mit kristallographischer Struktur bis zum zentralen Gitterelement (18) erstreckt.

**13.** Photovoltaisches Modul, **dadurch gekennzeichnet, dass** es umfasst:

- eine dünne Polymerschicht (21),
- zwei dünne Schichten (22, 23) eines thermoreaktivierbaren Klebers, darunter eine erste (22) und eine zweite (23) dünne Schicht eines thermoreaktivierbaren Klebers, wobei die erste dünne Schicht (22) aus thermoreaktivierbarem Kleber auf der dünnen Polymerschicht (21) abgeschieden ist,
- eine leitfähige Schicht (24), die aus einer Vielzahl von photovoltaischen Zellen, wie sie gemäß Anspruch 12 definiert sind, und aus zwei Kupferbändern (25) gebildet ist, die an jeweiligen Enden der leitfähigen Schicht, die aus einer Vielzahl von photovoltaischen Zellen gebildet ist, angeordnet sind, wobei die photovoltaischen Zellen (31) in Form von Bändern und die zwei Kupferbänder (25) zwischen der ersten (22) und der zweiten (23) dünnen Schicht aus thermoreaktivierbarem Kleber parallel zueinander, geneigt in Bezug auf die dünnen Schichten (22, 23) aus thermoreaktivierbarem Kleber angeordnet sind und sie einander überlappen, derart, dass eine Reihe von photovoltaischen Zellen (31) und Kupferbänder (25) in Kontakt gemäß einer Richtung parallel zu den dünnen Schichten (22, 23) aus thermoreaktivierbarem Kleber gebildet werden, und die Vielzahl der photovoltaischen Zellen (31) und die zwei Kupferbänder (25) eine Reihenverbindung bilden, und
- eine dünne Schicht (30) aus Polymethylmethacrylat, die auf der zweiten dünnen Schicht (23) aus thermoreaktivierbarem Kleber abgeschieden ist.

**14.** Verfahren zum Abscheiden von dünnen Schichten auf Siliziumbasis auf ein Metallsubstrat mit kristallographischer Struktur, wie es nach einem beliebigen der Ansprüche 1 bis 5 definiert ist, **dadurch gekennzeichnet, dass** es durch ein Verfahren der chemischen Gasphasenabscheidung realisiert ist, wobei die Temperatur des Plasmas kleiner als 300°C ist, vorzugsweise in der Größenordnung von 200°C liegt.

**15.** Verfahren zum Abscheiden von dünnen Schichten auf Siliziumbasis nach Anspruch 14, **dadurch gekennzeichnet, dass** das Verfahren der chemischen Gasphasenabscheidung (CVD) ein Verfahren der radiofrequenzplasmaunterstützten chemischen Gasphasenabscheidung (RFPECVD) ist, wobei das Plasma eine Gasmischung aus $SiF_4$, Wasserstoff und Argon ist und die verwendete Radiofrequenzleistung in der Größenordnung von 16 W liegt.

**16.** Verfahren zur Abscheidung von dünnen Schichten auf Siliziumbasis nach einem beliebigen der Ansprüche 14 oder 15, **dadurch gekennzeichnet, dass** das epitaktische Wachstum des Siliziums aus den Nanokristallen des in dem Plasma synthetisierten Siliziums erhalten wird.

**Claims**

**1.** A crystallographically textured metallic substrate (1) including a connection surface (2) and a surface (3) intended to receive a thin layer deposit, the aforementioned crystallographically textured metallic substrate (1) being made up of an alloy presenting a cubic crystalline system with centred faces and a predominantly cubic crystallographic texture {100} <001>, the surface intended to receive a thin layer deposit (3) including grains (4) mainly presenting crystallographic planes {100} parallel to the surface (3) intended to receive a thin layer deposit,
**characterised in that**:

- the alloy is an iron-nickel alloy with a composition including in % in weight relative to the total weight of the aforementioned alloy:

$Ni \geq 30$ %,
$Cu \leq 15$ %,
$Cr \leq 15$ %,
$Co \leq 12$ %,
$Mn \leq 5$ %,
$S < 0.0007$ %,
$P < 0.003$ %,
$B < 0.0005$ %,
$Pb < 0.0001$ %,

- the percentages in nickel, chromium, copper, cobalt and manganese are such that the alloy satisfies the following condition:

$34 \% \leq (Ni + Cr + Cu/2 + Co/2 + Mn)$, and

- the alloy includes up to 1% in weight of one or several deoxidising elements chosen among silicon, magnesium, aluminium and calcium, the rest of the elements representing the alloy being iron and impurities,

and **in that** said crystallographically textured device comprises a thin polycrystalline silicon-based layer (11) deposited on said crystallographically textured metallic substrate (1), the thin polycrystalline layer (11) presenting a preferred crystallographic orientation {100} and {111}.

2. A crystallographically textured metallic substrate according to claim 1, **characterised in that** the percentages in nickel, chromium, copper, cobalt and manganese of said crystallographically textured metallic substrate are such that the alloy satisfies the following condition:

$34 \% \leq (Ni + Cr + Cu/2 + Co/2 + Mn) \leq 54 \%$,

- the average expansion coefficient of the alloy, $\alpha_{20}^{100}$, between 20°C and 100°C, being greater than $10^{-6}$ $K^{-1}$, and preferably comprised between $10^{-6}$ $K^{-1}$ and $10.10^{-6}$ $K^{-1}$.

3. A crystallographically textured metallic substrate according to any one of claims 1 or 2 claim 1, **characterised in that** the surface (3) intended to receive a thin layer deposit of the crystallographically textured metallic substrate (1) presents a roughness $R_a$ less than 150 nm, and preferably less than 50 nm.

4. A crystallographically textured metallic substrate according to any one of claims 1 to 3, **characterised in that** the crystallographically textured metallic substrate (1) is thin with a thickness between 0.5 mm and 0.05 mm, preferably about 0.1 mm.

5. A crystallographically textured metallic substrate according to any one of claims 1 to 4, **characterised in that** the grains (4) on the surface (3) intended to receive a thin layer deposit are etched in the form of a pyramid presenting planes {111} and steps (12) according to the planes {100} so as to form a blazed grating.

6. A crystallographically textured device, **characterised in that** it includes a crystallographically textured metallic substrate (1), as defined according to any one of claims 1 to 5, on which a thin polycrystalline silicon-based layer has been deposited, (11), the thin polycrystalline layer (11) presenting a preferred crystallographic orientation {100} and {111}.

7. A crystallographically textured device according to claim 6, **characterised in that** the crystalline lattice parameter of the crystallographically textured metallic substrate (1) is the same or almost the same as that of the thin polycrystalline silicon-based layer (11).

8. A crystallographically textured device according to any one of claims 6 or 7, **characterised in that** the average expansion coefficient of the alloy representing the crystallographically textured metallic substrate (1) is similar to that of the thin polycrystalline layer (11).

9. A crystallographically textured device according to any one of claims 6 to 8, characterised that the thin polycrystalline silicon-based layer (11) presents a thickness less than 10 $\mu$m, and includes silicon crystals with a dimension between 0.1 $\mu$m and 2 $\mu$m.

10. A photovoltaic cell characterised that it includes a crystallographically textured device (13) according to any one of claims 6 to 9.

11. A photovoltaic cell according to claim 10 **characterised in that** it includes:

- a crystallographically textured device (13) in which:

• the crystallographically textured metallic substrate (1) presents a nickel content equal to 41% in weight relative to the alloy's total weight representing the metallic substrate (1),
• the silicon of the thin polycrystalline silicon layer (11) is doped,

**EP 2 031 082 B1**

- a thin intrinsic polycrystalline silicon layer (14) deposited on the crystallographically textured device (13),
- a thin doped polycrystalline silicon layer (15), deposited on the thin intrinsic polycrystalline silicon layer (14),
- a thin layer of a transparent conductive oxide (16) deposited on the thin doped polycrystalline silicon layer (15), and
- a metallic grid (17) placed on the thin transparent conductive oxide layer (16) and including several elements including a central grid element (18).

12. A photovoltaic cell according to claim 11, **characterised in that** a connector (19) linked to the central grid element (18) and emerging outside of the photovoltaic cell through the connection surface (2) of the crystallographically textured metallic substrate (1) passes through the crystallographically textured device (13) and the different thin layers (14, 15, 16), the aforementioned connector (19) being surrounded by an insulator (20) extending from the connection surface (2) of the crystallographically textured metallic substrate (1) to the central grid element (18).

13. A photovoltaic module **characterised in that** it includes:

- a thin layer of polymer (21),
- two thin layers of thermoreactivable glue (22, 23) including a first (22) and a second (23) thin layer of thermoreactivable glue, the first thin layer of thermoreactivable glue (22) being deposited on the thin layer of polymer (21),
- a conductive layer (24) formed of a multiplicity of photovoltaic cells according to claim 12, and two copper strips (25) placed on the respective ends of the conductive layer formed of a multiplicity of photovoltaic cells (31), the aforementioned photovoltaic cells (31) being in the form of strips and the two copper strips being placed between the first (22) and second (23) thin layers of thermoreactivable glue (22, 23), parallel one in relation to the other, sloped in relation to the thin layers of thermoreactivable glue (22, 23) and by overlapping so as to form a row of photovoltaic cells (31) and copper strips (25) in contact according to a direction parallel to the thin layers of thermoreactivable glue (22, 23), the multiplicity of photovoltaic cells and the two copper strips (25) forming a serial connection, and
- a thin layer of polymethylmethacrylate (30) deposited on the second thin layer of thermoreactivable glue (23).

14. A deposit procedure of thin silicon-based layers on a crystallographically textured metallic substrate (1) according to any one of claims 1 to 5, **characterised in that** it is achieved by chemical deposit in vapour phase (CVD), the temperature of the plasma being less than 300°C, preferably in the region of 200°C.

15. A deposit procedure of thin silicon-based layers according to claim 14 **characterised in that** the chemical deposit in vapour phase (CVD) is a chemical deposit in vapour phase assisted by radiofrequency plasma (RFPECVD), the plasma including a gassy mix of $SiF_4$, hydrogen and argon, and the radiofrequency power used being in the region of 16 W.

16. A deposit procedure of thin silicon-based layers according to any one of claims 14 or 15, **characterised in that** the epitaxial growth of silicon is obtained from silicon nanocrystals synthesised in the plasma.

FIGURE 1

FIGURE 2

FIGURE 3

Intensité  Couleur

Intensité  Couleur

FIGURE 4

FIGURE 5a

FIGURE 5b

9

3

40

1

12

4

10

2

**FIGURE 6**

4

10

**FIGURE 7**

FIGURE 8

FIGURE 9

**FIGURE 10**

**FIGURE 11**

FIGURE 12

FIGURE 13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- EP 0571632 A
- WO 2005121414 A1
- WO 9617388 A
- US 5340410 A
- EP 0792943 A

### Littérature non-brevet citée dans la description

- **ROEDERN, K. ZWEIBEL ; HS. ULLAL.** The role of polycrystalline thin-film PV technologies for achieving mid-term marketcompetitive PV modules. *B.- 31st IEEE Photovoltaics Specialists Conference and Exhibition - NREL/CP-520-37353 - Lake Buena Vista, Florida,* 03 Janvier 2005
- **BERGMANN ; JH. WERNER.** The future of crystalline silicon films on foreign substrates. *Thin Solid Films,* 2002, vol. 403-404, 2002
- **T. MATSUYAMA ; N. BADA ; T. SAWADA ; S. TSUGE ; K. WAKISAKA ; S. TSUDA.** High-quality polycrystalline silicon thin film prepared by a solide phase crystallisation method. *J. of non- Crystalline Solids,* 1996, vol. 198-200, 940-944
- Recrystallisation and related annealing phenomena. 1995, 328
- **K. INOUE ; N. TSUJI ; Y. SAITO.** Ultra-Grain refinement of 36%Ni steel by accumulative roll-bonding process. *International symposium on Ultrafine Grained Steels,* 2001, 126-129
- **A. ABRAMOV ; Y. DJERIDANE ; R. VANDERHAGHEN ; P. ROCA ; CABARROCAS.** Large grain µc-Si:H films deposited at low temperature: growth process and electronic properties. *J. Non Cryst. Solids,* 2006, vol. 352, 964-967
- **P. ROCA I CABARROCAS ; TH NGUYEN-TRAN ; Y. DJERIDANE ; A. ABRAMOV ; E. JOHNSON ; G. PATRIARCHE.** Synthesis of silicon nanocrystals in silane plasmas for nanoelectronics and large area electronic devices. *J. Phys. D: Appl. Phys.,* 2007, vol. 40, 2258-2266